# EUROPEAN PATENT SPECIFICATION

(11) **EP 2 204 698 B1**
(45) Date of publication and mention of the grant of the patent: **08.08.2018**
(21) Application number: 09015549.0
(22) Date of filing: 16.12.2009
(51) Int. Cl.: G03F 7/32, G03F 7/40

(54) **Plate surface treatment agent for lithographic printing plate and method for treating lithographic printing plate**
Plattenoberflächenbehandlungsmittel für eine lithografische Druckplatte und Verfahren zur Behandlung der lithografischen Druckplatte
Agent de traitement de surface pour plaque d'impression lithographique et procédé pour traiter une plaque d'impression lithographique

(30) Priority: 06.01.2009 JP 2009000571
(43) Date of publication of application: 07.07.2010
(73) Proprietor: FUJIFILM Corporation, Minato-ku Tokyo (JP)
(72) Inventor: Fujii, Shigekatsu, Haibara-gun Shizuoka (JP); Aoshima, Norio, Haibara-gun Shizuoka (JP); Watanabe, Toshihiro, Haibara-gun Shizuoka (JP); Kubota, Yasuhiro, Haibara-gun Shizuoka (JP)
(74) Representative: Hoffmann Eitle

(56) References cited:
- EP-A2- 1 510 866
- JP-A- 2007 038 483

## Description

The present invention relates to a method for treating a lithographic printing plate.

A lithographic printing plate conventionally comprises a photosensitive resin layer provided on a support having a hydrophilic surface. As for the plate-making method thereof, a desired printing plate is usually obtained by surface exposure (mask exposure) via a lith film and then removal of the nonimage area with a developer. However, with the recent progress of digitization techniques, a computer-to-plate (CTP) technique of direct exposure on the plate surface by scanning according to digitized image data with highly directional light, for example, a laser beam, without using a lith film has been developed. Photosensitive lithographic printing plates (lithographic printing plate precursors) adapted for the technique have also been developed.

As the lithographic printing plate precursors suitable for exposure with a laser beam, lithographic printing plate precursors having a polymerizable photosensitive layer can be cited. Compared with other conventional photosensitive layers it is easy to increase the sensitivity in the polymerizable photosensitive layer by selecting a polymerization initiator or a polymerization initiation system (hereinafter also simply referred to as an 'initiator' and an 'initiation system').

As a laser light source, for example, a semiconductor laser of 405 nm or 830 nm or an FD-YAG laser can be used. In recent years, a CTP system equipped with a semiconductor laser of 405 nm or 830 nm has become widespread in view of the system cost and the handling properties.

When making a lithographic printing plate, a plate surface treatment agent (a so-called gumming liquid) is applied in order to protect a non-image
area and an image area in the final step. This step is called gumming.

As the plate surface treatment agent, for example, those of JP-A-2006-11413 (JP-A denotes a Japanese unexamined patent application publication), JP-A-2005-114892 and JP-A-2007-45114 are known.

JP-A-2006-11413 (JP-A denotes a Japanese unexamined patent application publication) discloses a method for treating a photosensitive lithographic printing plate in which a photosensitive lithographic printing plate having on an aluminum plate support a photopolymerizable photosensitive layer comprising a polymerizable ethylenic double bond-containing compound, a photopolymerization initiator, and a polymer binder is imagewise exposed and processed with a developer that contains substantially no silicate, and the plate surface is treated at 40°C to 90°C with a phosphonic acid compound-containing plate surface protecting agent.

Furthermore, JP-A-2005-114892 discloses a method for treating a photosensitive lithographic printing plate in which a photosensitive lithographic printing plate having on an aluminum plate support a photopolymerizable photosensitive layer comprising a polymerizable ethylenic double bond-containing compound, a photopolymerization initiator, and a polymer binder is imagewise exposed and processed, treated with a plate surface protecting agent comprising (A) a phosphonic acid compound having a molecular weight of less than 2000 and (B) a phosphonic acid compound having a molecular weight of at least 2000, and subsequently heated at 50°C to 200°C.

Moreover, JP-A-2007-45114 discloses a method for treating a lithographic printing plate, the method comprising carrying out a treatment with a surface treatment agent or processing agent containing substantially no silicic acid or a salt thereof during surface treatment and processing of an aluminum support, and a treatment in a post-processing step with a plate surface treatment agent containing a compound that has a phosphoric acid or phosphonic acid group in the molecule and that does not itself have film-forming properties.

Furthermore, as a printing chemical used in dampening water, etc., JPA-2007-38483 discloses a printing chemical containing a water-soluble polymer having a sulfonic acid group and an adsorbing group that can be adsorbed on the surface of a lithographic printing plate support.

JP-A-2007/038483 discloses a plate surface treatment agent containing a water soluble vinyl copolymer comprising a monomer unit with a sulfonic group and a monomer unit with a carboxylic group or a phosphoric acid group optionally in the form of corresponding salts.

It is an object of the present invention to provide a method for treating a lithographic printing plate.

According to a first aspect, there is provided a method for treating a lithographic printing plate using an automatic processor comprising the steps of: imagewise exposing a lithographic printing plate precursor; processing using a developer; and carrying out a plate surface treatment using a plate surface treatment agent comprising a vinyl copolymer comprising a monomer unit having at least one group selected from a phosphonic acid group, a phosphoric acid group, a carboxylic acid group, and a salt of these groups and a monomer unit having a betaine structure represented by Formulae (U-7) or (U-8): 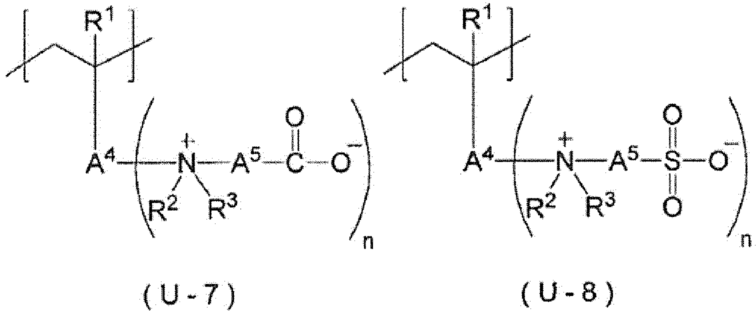 wherein R¹ denotes a hydrogen atom or an alkyl group; R² and R³ independently denote a hydrogen atom or a monovalent hydrocarbon group; A⁴ denotes an (n+1)-valent organic group; the A⁵s independently denote a divalent organic group and n denotes an integer of 1 or more.

Preferably the monomer unit having at least one group selected from a phosphonic acid group, a phosphoric acid group, a carboxylic acid group, and a salt of these groups is a monomer unit having at least one group selected from a phosphonic acid group, a phosphoric acid group and a salt of these groups.

Preferably the copolymer comprises, relative to the total monomer units of the copolymer, 2-70 mole % of the monomer units having at least one group selected from a phosphonic acid group, a phosphoric acid group, a carboxylic acid group, and a salt of these groups.

Preferably the copolymer comprises, relative to the total monomer units of the copolymer, 30-98 mole % of the monomer units having a betaine structure.

Preferably the plate surface treatment agent comprises 0.005 to 10 wt.% of the vinyl copolymer.

Preferably the plate surface treatment agent further comprises a water-soluble polymer compound other than the vinyl copolymer. In this case, the water-soluble polymer is preferably gum Arabic, a cellulose derivative and a modified product thereof, polyvinyl alcohol and a derivative thereof, polyvinylpyrrolidone, a vinyl methyl ether/maleic anhydride copolymer, a vinyl acetate/maleic anhydride copolymer, a styrene/maleic anhydride copolymer, a water-soluble soybean polysaccharide, starch, a starch derivative, pullulan, a pullulan derivative, gelatine or hemicellulose extracted from soybean.

Preferably the water-soluble polymer compound has a content of 0.1 to 25 wt.% relative to the total weight of the plate surface treatment agent.

Preferably the developer is an alkaline aqueous solution.

Preferably the lithographic printing plate precursor has a support that has been subjected to an electrochemical surface roughening treatment with a hydrochloric acid aqueous solution.

Preferably the lithographic printing plate precursor has a photosensitive layer comprising a sensitizing dye, a polymerization initiator and a binder polymer.

### BRIEF DESCRIPTION OF DRAWING

FIG. 1:A side view showing the concept of a brush graining step used in a mechanical surface roughening treatment in the production of an aluminum support.
FIG. 2: A graph showing one example of a diagram of an alternating current waveform used in an electrochemical surface roughening treatment in the production of an aluminum support.

### EXPLANATION OF REFERENCE NUMERALS AND SYMBOLS

21: aluminum plate
22, 24: roller-shaped brush
23: polishing slurry
25, 26, 27, 28: support roller

The method for treating a lithographic printing plate of the present invention are explained in detail below.

### (Plate surface treatment agent for lithographic printing plate)

The plate surface treatment agent for use in the present invention (hereinafter, also simply called a 'plate surface treatment agent', a 'plate surface protecting agent', or a 'finisher') comprises a vinyl copolymer (hereinafter, also called a 'specific copolymer') having a monomer unit (hereinafter, also called an 'acidic monomer unit') having at least one group selected from the group consisting of a phosphonic acid group, a phosphoric acid group, a carboxylic acid group, and a salt of these groups and a monomer unit (hereinafter, also called a 'hydrophilic monomer unit') having a betaine structure.

### (Specific copolymer)

The plate surface treatment agent for use in the present invention comprises a vinyl copolymer (specific copolymer) having an
acidic monomer unit and a hydrophilic monomer unit.

The acidic monomer unit is a monomer unit having at least one group selected from the group consisting of a phosphonic acid group (-PO(OH)₂), a phosphoric acid group (-OPO(OH)₂), a carboxylic acid group (-COOH), and a salt of these groups (-PO(OH)(OM), -PO(OM)₂, -OPO(OH)(OM), -OPO(OM)₂, - COOM (here, M denotes a countercation other than a proton (H⁺))), and is preferably a monomer unit having at least one group selected from the group consisting of a phosphonic acid group, a phosphoric acid group, and a salt of these groups.

As described above, the phosphonic acid group, phosphoric acid group, and carboxylic acid group in the acidic monomer unit may form a salt; the countercation other than a proton is not particularly limited, and may be an inorganic cation such as a metal cation, an organic cation such as a tetraalkylammonium ion, or a polymeric cation. Furthermore, the countercation may be a monovalent countercation or a di- or higher-valent countercation.

The acidic monomer unit is preferably a monomer unit represented by Formulae (U-1) to (U-3) below, and more preferably a monomer unit represented by Formula (U-1) or (U-2) below. 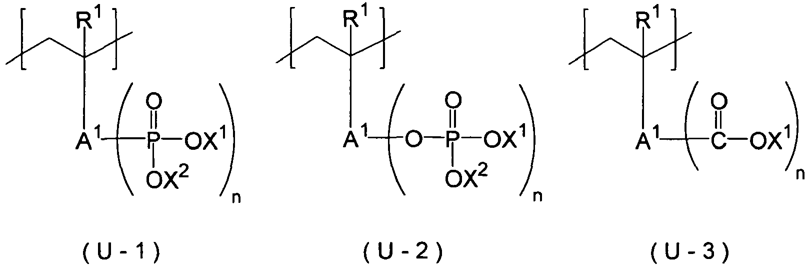 (In Formulae (U-1) to (U-3), R¹ denotes a hydrogen atom or an alkyl group, A¹ denotes a single bond or an (n+1)-valent organic group, X¹ and X² independently denote a hydrogen atom or a countercation other than a proton, and n denotes an integer of 1 or more.)

R¹ above denotes a hydrogen atom or an alkyl group, and is preferably a hydrogen atom or a methyl group.

The countercation other than a proton denoted by X¹ and X² above is not particularly limited; it may be an inorganic cation such as a metal cation, it may be an organic cation such as a tetraalkylammonium ion, or it may be a polymeric cation. Furthermore, the countercation may be a monovalent countercation or a di- or higher-valent countercation.

n above denotes an integer of 1 or more, and is preferably an integer of 1 to 5, more preferably 1 or 2, and particularly preferably 1.

The (n+1)-valent organic group denoted by A¹ above is preferably a group formed from at least one element selected from the group consisting of carbon, hydrogen, oxygen, and nitrogen, more preferably a group formed from at least one element selected from the group consisting of carbon, hydrogen, and oxygen, and yet more preferably a group formed by removing (n+1) hydrogen atoms from a hydrocarbon, or a group in which two or more groups selected from the group consisting of a group formed by removing m (here, m denotes an integer of 1 or more) hydrogen atoms from a hydrocarbon, an ester bond, and an ether bond are combined.

Furthermore, the acidic monomer unit is yet more preferably a monomer unit represented by Formula (U-4) or (U-5) below. 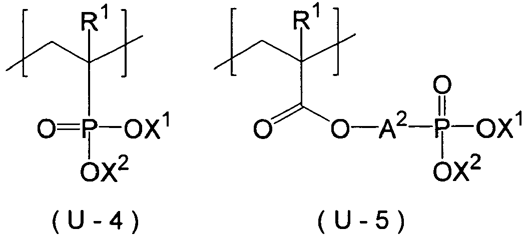 (In Formulae (U-4) and (U-5), R¹ denotes a hydrogen atom or an alkyl group, A² denotes a divalent organic group, and X¹ and X² independently denote a hydrogen atom or a countercation other than a proton.)

R¹, X¹, and X² in Formulae (U-4) and (U-5) have the same meanings as those of R¹, X¹, and X² in Formulae (U-1) to (U-3), and preferred ranges are also the same.

The divalent organic group denoted by A² in Formula (U-5) above is preferably a group formed from at least one element selected from the group consisting of carbon, hydrogen, and oxygen, more preferably an alkylene group or a group formed by combining two or more groups selected from the group consisting of an alkylene group, an ester bond, and an ether bond, yet more preferably an alkylene group or a group formed by combining two or more groups selected from the group consisting of an alkylene group and an ether bond, and particularly preferably an alkylene group or a polyalkyleneoxy group. In addition, the terminus, on the phosphorus atom side, of the polyalkyleneoxy group may be a carbon atom or may be an oxygen atom. Furthermore, the alkylene group and the polyalkyleneoxy group may be straight chain or branched.

With regard to the monomer unit represented by Formula (U-5), depending on whether the terminus of A² is a carbon atom or an oxygen atom, the terminal group of the monomer unit may be a phosphonic acid group or a salt thereof or may be a phosphoric acid group or a salt thereof.

Furthermore, the number of carbon atoms of A² in (U-4) and (U-5) is preferably 2 to 60, more preferably 2 to 20, and yet more preferably 2 to 10.

Preferred specific examples of the acidic monomer unit include monomer units represented by (A-1) to (A-6) below. Preferred examples also include monomer units in which the phosphonic acid group, phosphoric acid group, or carboxylic acid group of the monomer units represented by (A-1) to (A-6) below forms a salt. In the present invention, a hydrocarbon chain of a compound or a partial structure thereof is sometimes represented by a simplified structural formula in which symbols for carbon (C) and hydrogen (H) are omitted.

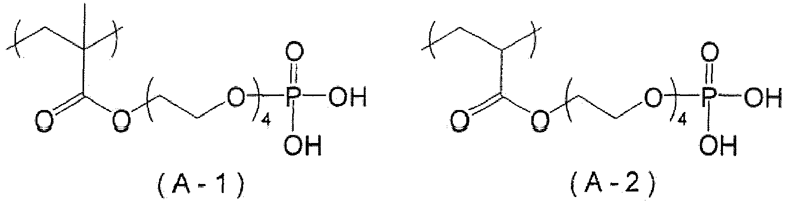

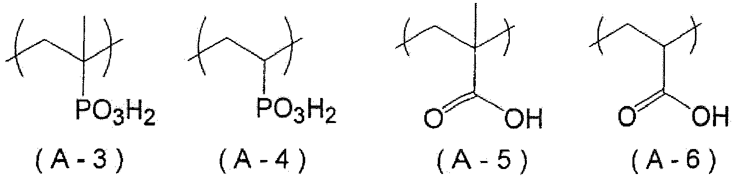

The specific copolymer that can be used in the present invention may have only one type of acidic monomer unit or may have two or more types of acidic monomer units.

The content ratio of the acidic monomer unit in the specific copolymer that can be used in the present invention is preferably 2 to 80 mole % relative to the total monomer units of the specific copolymer, more preferably 2 to 70 mole %, yet more preferably 5 to 50 mole %, and particularly preferably 10 to 40 mole %.

The hydrophilic monomer unit is a monomer unit having a betaine structure.

The betaine structure referred to here is a structure that has both a cationic structure and an anionic structure within one monomer unit and in which the charges are neutralized within the single monomer unit.

The cationic structure in the betaine structure is a quaternary nitrogen cation.

The anionic structure in the betaine structure is not particularly limited, but is -COO⁻ and/or -SO₃⁻.

The hydrophilic monomer unit is represented by Formula (U-7) or (U-8) below.

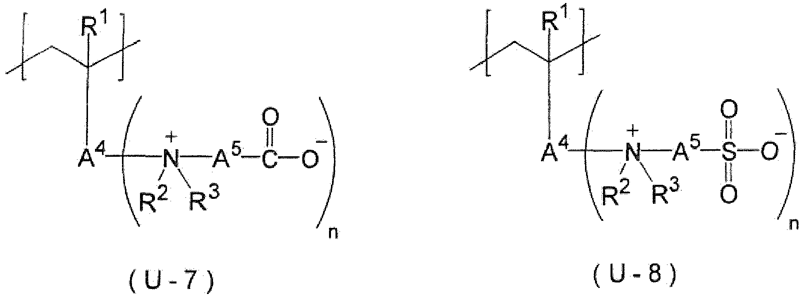

In Formulae (U-7) to (U-8), R¹ denotes a hydrogen atom or an alkyl group, R² and R³ independently denote a hydrogen atom or a monovalent hydrocarbon group, A⁴ denotes an (n+1)-valent organic group, the A⁵s independently denote a divalent organic group, and n denotes an integer of 1 or more.

R¹ and n in Formulae (U-7) to (U-8) have the same meanings as those of R¹, and n in Formulae (U-1) to (U-3), and preferred ranges are also the same.

The (n+1)-valent organic group denoted by A⁴ in Formulae (U-7) and (U-8) above is preferably a group formed from at least one element selected from the group consisting of carbon, hydrogen, oxygen, and nitrogen, more preferably a group formed from at least one element selected from the group consisting of carbon, hydrogen, and oxygen, and yet more preferably a group formed by removing (n+1) hydrogen atoms from a hydrocarbon or a group formed by combining two or more groups selected from the group consisting of a group formed by removing m (here, m denotes an integer of 1 or more) hydrogen atoms from a hydrocarbon and an ester bond.

The divalent organic group denoted A⁵ by in Formulae (U-7) and (U-8) above is preferably a group formed from at least one element selected from the group consisting of carbon, hydrogen, and oxygen, and more preferably an alkylene group. The alkylene group may be a straight chain or branched.

R² and R³ in Formulae (U-7) and (U-8) above independently denote a hydrogen atom or a monovalent hydrocarbon group, and are preferably monovalent hydrocarbon groups, more preferably alkyl groups having 1 to 8 carbon atoms, and yet more preferably methyl groups.

Furthermore, the hydrophilic monomer unit is yet more preferably a monomer unit represented by the following Formula (U-11) or Formula (U-12).

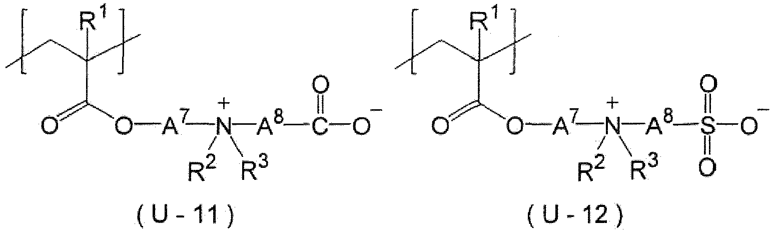

In Formulae (U-11) to (U-12), R¹ denotes a hydrogen atom or an alkyl group, R² and R³ independently denote a hydrogen atom or a monovalent hydrocarbon group, and A⁷ and A⁸ independently denote a divalent organic group.

R¹ in Formulae (U-11) to (U-12) has the same meanings as those of R¹ in Formulae (U-1) to (U-3), and preferred ranges are also the same.

R² and R³ in Formulae (U-11) and (U-12) have the same meanings as those of R² and R³ in Formulae (U-7) and (U-8) above, and preferred ranges are also the same.

A⁷ in Formulae (U-11) and (U-12) denotes a divalent organic group, and is preferably a straight-chain or branched alkylene group, more preferably a straight-chain or branched alkylene group having 2 to 20 carbon atoms, and yet more preferably a straight-chain or branched alkylene group having 2 to 10 carbon atoms.

A⁸ in Formulae (U-11) and (U-12) denotes a divalent organic group, and is preferably a straight-chain or branched alkylene group, more preferably a straight-chain or branched alkylene group having 1 to 10 carbon atoms, and yet more preferably a straight-chain or branched alkylene group having 1 to 4 carbon atoms.

Preferred specific examples of the hydrophilic monomer unit include monomer units represented by (H-5) to (H-8) below.

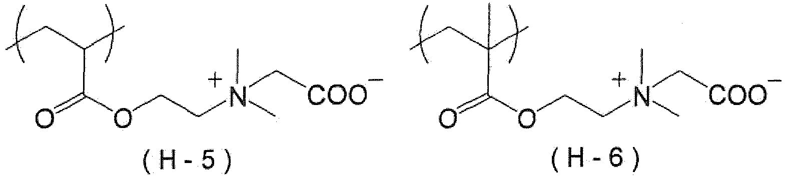

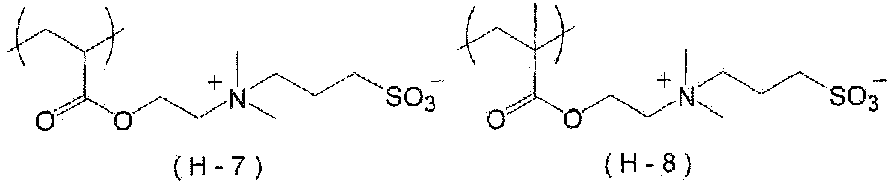

The specific copolymer that can be used in the present invention may have only one type of hydrophilic monomer unit or two or more types of hydrophilic monomer units.

The content ratio of the hydrophilic monomer unit in the specific copolymer that can be used in the present invention is preferably 30 to 98 mole % relative to the total monomer units of the specific copolymer, more preferably 40 to 90 mole %, and yet more preferably 50 to 90 mole %.

Furthermore, the specific copolymer that can be used in the present invention may have another monomer unit in addition to the acidic monomer unit and the hydrophilic monomer unit.

Said other monomer unit is not particularly limited, and may be a monomer unit obtained by copolymerization of a known monomer.

Furthermore, preferred examples of said other monomer unit include a monomer unit having a hydroxy group and/or a polyalkyleneoxy group.

The content ratio of said other monomer unit in the specific copolymer that can be used in the present invention is preferably no greater than 40 mole % relative to the total monomer units of the specific copolymer, more preferably no greater than 30 mole %, and yet more preferably no greater than 20 mole %.

The specific copolymer is a vinyl copolymer.

The vinyl copolymer referred to here is a copolymer obtained by copolymerization of two or more types of monomers having an ethylenically unsaturated bond, such as an acrylate, a methacrylate, a styrene, an aromatic vinyl compound, an aliphatic vinyl compound, an allyl compound, acrylic acid, and methacrylic acid.

The specific copolymer may be any copolymer such as a random copolymer, a block copolymer, or a graft copolymer, and is preferably a random copolymer.

Furthermore, the acidic monomer unit, the hydrophilic monomer unit, and said other monomer unit are monomer units obtained from monomers having an ethylenically unsaturated bond.

The plate surface treatment agent for use in the present invention may comprise one type of specific copolymer on its own or two or more types thereof.

The content of the specific copolymer in the plate surface treatment agent of the present invention is preferably 0.005 to 10 wt %, more preferably 0.01 to 5 wt %, and yet more preferably 0.1 to 3 wt %. When in the abovementioned range, an effect in preventing staining of a non-image area and a halftone image area is obtained.

The weight-average molecular weight of the specific copolymer is preferably at least 5,000 and more preferably at least 10,000, and is preferably no greater than 1,000,000 and more preferably no greater than 500,000.

The number-average molecular weight of the specific copolymer is preferably at least 1,000 and more preferably at least 2,000, and is preferably no greater than 500,000 and more preferably no greater than 300,000.

The polydispersity (weight-average molecular weight/number-average molecular weight) of the specific copolymer is preferably 1.1 to 10.

The plate surface treatment agent for use in the present invention may further contain, in addition to the above-mentioned compound, a water-soluble polymer compound other than the above-mentioned specific copolymer, an inorganic acid, a salt of an inorganic acid, an organic acid, a salt of an organic acid, a surfactant other than the above-mentioned compound, an organic solvent, a nitrate salt, a sulfate salt, a chelating agent, a preservative, an antifoaming agent, etc.

The various types of components are described below.

It is preferable for the plate surface treatment agent for use in the present invention to comprise a water-soluble polymer compound having film-forming properties other than the above-mentioned specific copolymer in order to maintain hydrophilicity and protect the plate surface from scratches. The specific copolymer may be water-soluble or may not be water-soluble, but is preferably water-soluble.

Examples of the water-soluble polymer compound other than the above-mentioned specific copolymer include gum arabic, a cellulose derivative (e.g. carboxymethylcellulose, carboxyethylcellulose, methylcellulose,
hydroxypropylcellulose, methylpropylcellulose, etc.) and modified products thereof, polyvinyl alcohol and derivatives thereof, polyvinylpyrrolidone, polyacrylamide, a vinyl methyl ether/maleic anhydride copolymer, a vinyl acetate/maleic anhydride copolymer, a styrene/maleic anhydride copolymer, a starch derivative (e.g. dextrin, maltodextrin, enzymatically-decomposed dextrin, hydroxypropylated starch, hydroxypropylated starch enzymatically-decomposed dextrin, carboxymethylated starch, phosphorylated starch, cyclodextrin), pullulan, and a pullulan derivative.

Furthermore, examples of other starch derivatives that can be used as the water-soluble polymer compound include roasted starch such as British gum, enzymatically-modified dextrins such as enzyme dextrin and Schardinger dextrin, oxidized starch such as solubilized starch, pregelatinized starch such as modified pregelatinized starch and unmodified pregelatinized starch, esterified starch such as starch phosphate, fatty starch, starch sulfate, starch nitrate, starch xanthate, and starch carbamate, etherified starch such as a carboxyalkyl starch, a hydroxyalkyl starch, a sulfoalkyl starch, cyanoethyl starch, allyl starch, benzyl starch, carbamylethyl starch, and a dialkylamino starch, crosslinked starch such as methylol-crosslinked starch, hydroxyalkyl-crosslinked starch, phosphoric acid-crosslinked starch, and dicarboxylic acid-crosslinked starch, and starch graft polymers such as a starch polyacrylamide copolymer, a starch polyacrylic acid copolymer, a starch polyvinyl acetate copolymer, a starch polyacrylonitrile copolymer, a cationic starch polyacrylic acid ester copolymer, a cationic starch vinyl polymer copolymer, a starch polystyrene maleic acid copolymer, a starch polyethylene oxide copolymer, and a starch polypropylene copolymer.

Preferred examples of natural polymer compounds that can be used as the water-soluble polymer compound include a water-soluble soybean polysaccharide, starch, gelatin, hemicellulose extracted from soybean, starch such as sweet potato starch, potato starch, tapioca starch, wheat starch, and corn starch, those obtained from algae such as carrageenan, laminaran, seaweed mannan, glue plant, Irish moss, agar, and sodium alginate, vegetable mucilages such as Abelmoschus manihot, mannan, quince seed, pectin, tragacanth gum, karaya gum, xanthine gum, guar bean gum, locust bean gum, carob gum, and benzoin gum, microbial mucilages such as homopolysaccharides such as dextran, glucan, and levan and heteropolysaccharides such as succinoglucan and xanthan gum, and proteins such as animal glue, gelatin, casein, and collagen.

Among them, a starch derivative such as gum arabic, dextrin, or hydroxypropyl starch, carboxymethylcellulose, a soybean polysaccharide, may preferably be used.

The content of the water-soluble polymer compound other than the above-mentioned specific copolymer is preferably 0.1 to 25.0 wt %, and more preferably 0.3 to 20.0 wt %.

It is generally advantageous for the plate surface treatment agent for use in the present invention to be used in an acid region of pH 2 to 6. In order to adjust to such a pH, it is preferable for a pH-adjusting agent such as a mineral acid, an organic acid, or a salt thereof to be added to the plate surface treatment agent.

Examples of the pH-adjusting agent include a mineral acid such as nitric acid, sulfuric acid, phosphoric acid, metaphosphoric acid, or polyphosphoric acid. Examples further includes an organic acid such as acetic acid, oxalic acid, citric acid, malic acid, malonic acid, tartaric acid, p-toluenesulfonic acid, lactic acid, levulinic acid, phytic acid, or an organic phosphonic acid. Examples of a salt that can preferably be used include disodium hydrogen phosphate, dipotassium hydrogen phosphate, diammonium hydrogen phosphate, sodium dihydrogen phosphate, potassium dihydrogen phosphate, ammonium dihydrogen phosphate, potassium pyrophosphate, sodium hexametaphosphate, sodium tripolyphosphate, sodium nitrate, potassium nitrate, ammonium nitrate, and sodium sulfate.

With regard to the pH-adjusting agent, one type thereof may be used on
its own or two or more types thereof may be used in combination. The amount thereof added is preferably 0.01 to 3.0 wt %.

The plate surface treatment agent for use in the present invention preferably further comprises a surfactant.

Examples of the surfactant include an anionic surfactant and/or a nonionic surfactant.

Examples of the anionic surfactant include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkylphenoxypolyoxyethylene propylsulfonic acid salt, a polyoxyethylene alkylsulfophenyl ether salt, sodium *N*-methyl-*N*-oleyltaurine, a disodium N-alkylsulfosuccinic acid monoamide, a petroleum sulfonic acid salt, sulfated castor oil, sulfated tallow oil, a sulfate ester of a fatty acid alkyl ester, an alkylsulfate ester, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkyl phosphate ester, a polyoxyethylene alkyl ether phosphate ester, a polyoxyethylene alkyl phenyl ether phosphate ester, a partially saponified styrene-maleic anhydride copolymer, a partially saponified olefinmaleic anhydride copolymer, and a naphthalenesulfonic acid salt formalin condensate.

Among them, a dialkylsulfosuccinic acid salt, an alkylsulfate ester, and an alkylnaphthalenesulfonic acid salt are particularly preferably used.

Examples of the nonionic surfactant include a polyoxyethylene alkyl ether, a polyoxyethylene alkyl phenyl ether, a polyoxyethylenepolyoxypropylene block copolymer, a glycerol fatty acid partial ester, a sorbitan fatty acid partial ester, a pentaerythritol fatty acid partial ester, a propylene glycol monofatty acid ester, a sucrose fatty acid partial ester, a polyoxyethylene sorbitan fatty acid partial ester, a polyoxyethylene castor oil ether, a polyoxyethylene sorbitol fatty acid partial ester, a polyethylene glycol
fatty acid ester, a polyglycerol fatty acid partial ester, a polyoxyethylene glycerol fatty acid partial ester, a fatty acid diethanolamide, an *N,N*-bis-*2*-hydroxyalkylamine, a polyoxyethylene alkylamine, a triethanolamine fatty acid ester, and a trialkylamine oxide.

Among them, a polyoxyethylene alkyl ether, a polyoxyethylenepolyoxypropylene block copolymer, a polyoxyethylene castor oil ether, etc. are preferably used.

Furthermore, acetylene glycol-based and acetylene alcohol-based oxyethylene adducts, and fluorine-based, silicone-based, etc. anionic and nonionic surfactants can also be used similarly.

Two or more types of these surfactants may be used in combination. For example, it is preferable to use two different types of anionic surfactants in combination or to use an anionic surfactant and a nonionic surfactant in combination. It is preferable to appropriately select and use these compounds while taking into consideration the influence on the environment.

It is not necessary to particularly limit the amount of surfactant used, but it is preferably contained in the plate surface treatment agent at 0.01 to 20 wt %.

It is preferable to add to the plate surface treatment agent for use in the present invention an organic solvent having a boiling point of at least 130°C in order to protect the oleophilicity of an image area. This type of organic solvent exhibits an effect in removing a trace amount of residual photosensitive film attached to the hydrophilic layer of a non-image area, thus enhancing the hydrophilicity of the non-image area.

With regard to specific examples of the organic solvent having a boiling point of at least 130°C, examples of alcohols include n-hexanol, 2-ethylbutanol, n-heptanol, 2-heptanol, 3-heptanol, 2-octanol, 2-ethylhexanol, 3,5,5-trimethylhexanol, nonanol, *n*-decanol, undecanol, n-dodecanol, trimethylnonyl alcohol, tetradecanol, cyclohexanol, benzyl alcohol, and tetrahydrofurfuryl alcohol.

Examples of ketones include methyl *n*-amyl ketone, methyl *n*-hexyl ketone, ethyl *n*-butyl ketone, di-n-propyl ketone, diacetone alcohol, and cyclohexanone.

Examples of esters include *n*-amyl acetate, isoamyl acetate, methylisoamyl acetate, methoxybutyl acetate, benzyl acetate, ethyl lactate, butyl lactate, *n*-amyl lactate, benzoic acid esters such as methyl benzoate, ethyl benzoate, and benzyl benzoate, phthalic acid diesters such as dimethyl phthalate, diethyl phthalate, dibutyl phthalate, di-2-ethylhexyl phthalate, dioctyl phthalate, dinonyl phthalate, didecyl phthalate, dilauryl phthalate, and butylbenzyl phthalate, aliphatic dibasic acid esters such as dioctyl adipate, butyl glycol adipate, dioctyl azelate, dibutyl sebacate, di(2-ethylhexyl) sebacate, and dioctyl sebacate, epoxylated triglycerides such as epoxylated soybean oil, and phosphoric acid esters such as tricresyl phosphate, trioctyl phosphate, and trischloroethyl phosphate.

Examples of amides include *N,N-*dimethylformamide, *N,N-*dimethylacetamide, *N*-methyl-2-pyrrolidone, *N*-ethyl-2-pyrrolidone, and N-butyl-2-pyrrolidone.

Examples of polyhydric alcohols and derivatives thereof include ethylene glycol, ethylene glycol monomethyl ether acetate, ethylene glycol monoethyl ether acetate, ethylene glycol butyl ether, ethylene glycol dibutyl ether, ethylene glycol isoamyl ether, ethylene glycol monophenyl ether, ethylene glycol monophenyl ether acetate, ethylene glycol benzyl ether, ethylene glycol monohexyl ether, methoxyethanol, diethylene glycol, diethylene glycol monomethyl ether, diethylene glycol monoethyl ether, diethylene glycol monobutyl ether, diethylene glycol monobutyl ether acetate, diethylene glycol dimethyl ether, diethylene glycol diethyl ether, diethylene glycol dibutyl ether, triethylene glycol, triethylene glycol monomethyl ether, triethylene glycol monoethyl ether, tetraethylene glycol, propylene glycol, dipropylene glycol, propylene glycol monoethyl ether, propylene glycol monobutyl ether, 1-butoxyethoxypropanol, dipropylene glycol, dipropylene glycol monomethyl ether, dipropylene glycol monoethyl ether, tripropylene glycol monomethyl ether, tripropylene glycol monobutyl ether, butylene glycol, hexylene glycol, octylene glycol, glycerol, diglycerol, trimethylolpropane, glycerol monoacetate, and glycerol triacetate.

Examples of hydrocarbon-based solvents include petroleum fraction aromatic and aliphatic compounds having a boiling point of 160°C or greater and squalane.

As conditions when selecting the organic solvent having a boiling point of at least 130°C, there can be cited the environmental safety thereof and, in particular, odor. With regard to these solvents, one type thereof may be used on its own, or two or more types thereof may be used in combination.

The amount of organic solvent having a boiling point of at least 130°C in the plate surface treatment agent is preferably 0.1 to 5.0 wt %, and more preferably 0.3 to 3.0 wt %.

In the plate surface treatment agent, these organic solvents may be solubilized by a surfactant to thus become a solution type, or may be emulsified-dispersed as an oil phase to thus become an emulsion type.

The plate surface treatment agent may comprise a nitrate or a sulfate.

Examples of the nitrate or sulfate that can be contained in the plate surface treatment agent include magnesium nitrate, sodium nitrate, potassium nitrate, ammonium nitrate, sodium sulfate, potassium sulfate, ammonium sulfate, sodium hydrogen sulfate, and nickel sulfate.

The amount thereof used in the plate surface treatment agent is preferably 0.05 to 1.0 wt %.

The plate surface treatment agent is usually often sold as a concentrate and is diluted by adding tap water, well water, etc. when used. Calcium ion, etc. contained in tap water or well water used for dilution adversely affects printing and might cause a printed material to be easily stained, and in order to
solve this defect it is preferable for the plate surface treatment agent to comprise a chelate compound.

Preferred examples of the chelate compound include polyphosphoric acid salts such as Na₂P₂O₇, Na₅P₃O₃, Na₃P₃O₉, Na₂O₄P(NaO₃P)PO₃Na₂, and Calgon (sodium polymetaphosphate), ethylenediaminetetraacetic acid, a potassium salt thereof, and a sodium salt thereof; dihydroxyethylglycine, a potassium salt thereof, and a sodium salt thereof; hydroxyiminodiacetic acid, a potassium salt thereof, and a sodium salt thereof; glycol ether diaminetetraacetic acid, a potassium salt thereof, and a sodium salt thereof; aminopolycarboxylic acids such as diethylenetriaminepentaacetic acid, a potassium salt thereof, and a sodium salt thereof; triethylenetetraminehexaacetic acid, a potassium salt thereof, and a sodium salt thereof, hydroxyethylethylenediaminetriacetic acid, a potassium salt thereof, and a sodium salt thereof; 1,2-diaminocyclohexanetetraacetic acid, a potassium salt thereof, and a sodium salt thereof; and 1,3-diamino-2-propanoltetraacetic acid, a potassium salt thereof, and a sodium salt thereof, nitrilotriacetic acid, a potassium salt thereof, and a sodium salt thereof; organic phosphonic acids such as 1-hydroxyethane-1,1-diphosphonic acid, a potassium salt thereof, and a sodium salt thereof; aminotri(methylenephosphonic acid), a potassium salt thereof, and a sodium salt thereof; ethylenediaminetetra(methylenephosphonic acid), a potassium salt thereof, and a sodium salt thereof; diethylenetriaminepenta(methylenephosphonic acid), a potassium salt thereof, and a sodium salt thereof; and hexamethylenediaminetetra(methylenephosphonic acid), a potassium salt thereof, and a sodium salt thereof, and phosphonoalkanetricarboxylic acids such as 2-phosphonobutanetricarboxylic acid-1,2,4, a potassium salt thereof, and a sodium salt thereof; 2-phosphonobutanonetricarboxylic acid-2,3,4, a potassium salt thereof, and a sodium salt thereof; and 1-phosphonoethanetricarboxylic acid-1,2,2, a potassium salt thereof, and a sodium salt thereof.

Instead of the sodium salt or the potassium salt of the above-mentioned chelate compound, an organic amine salt is also effective.

These chelate compounds are selected such that they are present stably in a plate surface treatment agent composition and do not inhibit printing properties.

The amount of chelate compound added is preferably 0.001 to 1.0 wt % relative to the plate surface treatment agent when used.

It is also possible to further add a preservative, an antifoaming agent, etc. to the plate surface treatment agent of the present invention.

Examples of the preservative include phenol or a derivative thereof, formalin, an imidazole derivative, sodium dehydroacetate, a 4-isothiazolin-3-one derivative, benzoisothiazolin-3-one, a benzotriazole derivative, an amidine guanidine derivative, a quaternary ammonium salt, derivatives of pyridine, quinoline, and guanidine, diazine, a triazole derivative, oxazole, an oxazine derivative, nitrobromo alcohol-based compounds such as 2-bromo-2-nitropropane-1,3-diol, 1,1-dibromo-1-nitro-2-ethanol, and 1,1-dibromo-1-nitro-2-propanol, and an omadine.

A preferred amount of preservative added is an amount that exhibits an effect stably toward bacteria, molds, yeasts, etc.; although it depends on the type of bacterium, mold, or yeast, it is preferably in the range of 0.01 to 4.0 wt % in the plate surface treatment agent, and it is preferable to use two or more types of preservatives in combination so that an effect is exhibited toward various types of molds and microbes.

Furthermore, as the antifoaming agent, a normal silicone-based self emulsifying type, emulsifying type, or a nonionic surfactant compound having an HLB (Hydrophile-Lipophile Balance) value of no greater than 5 may be used. A silicone antifoaming agent is preferable. Among them, any of an emulsifying-dispersing type and a solubilizing type may be used. The content of the antifoaming agent in the plate surface treatment agent is preferably 0.001 to 1.0 wt %.

The remainder of the plate surface protecting agent is preferably water.

When the plate surface protecting agent is prepared as a solution type or an emulsion type, it may be prepared in accordance with standard methods. For example, emulsifying-dispersing may be carried out by preparing an aqueous phase at a temperature of 40°C ± 5°C, stirring at high speed, slowly adding dropwise a prepared oil phase to the aqueous phase, stirring well, and then passing through a pressure type homogenizer, thus preparing an emulsion.

The plate surface treatment agent may be used for either a positive-working lithographic printing plate precursor or a negative working lithographic printing plate precursor, and may be used for making a lithographic printing plate from various types of lithographic printing plate precursors. Furthermore, a method for developing a lithographic printing plate precursor may be a thermal method or a photopolymer method.

### Negative-working photosensitive laver

A lithographic printing plate precursor that can be used in the present invention is not particularly limited, but is preferably a lithographic printing plate precursor having a negative-working photosensitive layer (hereinafter, also called an 'image formation layer' or a 'recording layer') containing (A) a sensitizing dye, (B) a polymerization initiator, (C) a polymerizable compound, and (D) a binder polymer.

### (A) Sensitizing dye

The photosensitive layer in the lithographic printing plate precursor used in the present invention preferably contains a sensitizing dye.

The sensitizing dye that can be used in the present invention is not particularly limited, and known sensitizing dyes can be used.

Adding, for example, a sensitizing dye having a maximum absorption at 300 to 450 nm, a sensitizing dye having a maximum absorption at 500 to 600 nm, or a sensitizing dye (an IR absorber) having a maximum absorption at 750
to 1,400 nm enables a high sensitivity lithographic printing plate precursor corresponding to a 405 nm violet laser, a 532 nm green laser, or an 830 nm IR laser, which are usually used in the present field, to be provided.

The sensitizing dye having a maximum absorption at 750 to 1,400 nm, suitably used in the present invention, is described in detail below. Furthermore, in the present invention, the 'sensitizing dye having a maximum absorption at 750 to 1,400 nm' is also called an 'IR absorber'. The IR absorber is preferably a dye or a pigment having an absorption maximum in the wavelength rigion of 750 nm to 1,400 nm.

As the dye, commercial dyes and known dyes described in the literature such as, for example, 'Senryo Binran' (Dye Handbook) (Ed. The Society of Synthetic Organic Chemistry, Japan, 1970) may be used.

Specific examples thereof include an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex. Among these dyes, a cyanine dye, a squarylium dye, a pyrylium salt, a nickel thiolate complex, and an indolenine cyanine dye are particularly preferable. Further, cyanine dye and an indolenine cyanine dye are more preferable, and particularly preferable examples include a cyanine dye represented by Formula (a) below.

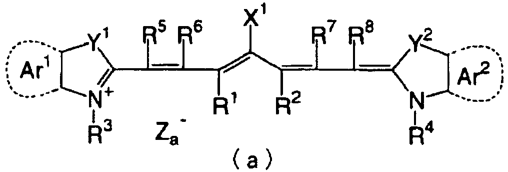

In Formula (a), X¹ denotes a hydrogen atom, a halogen atom, -NPh₂, X²-L¹, or the group shown below. Here, X² denotes an oxygen atom, a nitrogen atom, or a sulfur atom, L¹ denotes a hydrocarbon group having 1 to 12 carbon atoms, a hetero atom-containing aromatic ring, or a hetero atom-containing hydrocarbon group having 1 to 12 carbon atoms. The hetero atom referred to here means N, S, O, a halogen atom, or Se. Xₐ⁻ is defined in the same manner as for Zₐ⁻, which is described later, and R^{a} denotes a hydrogen atom or a substituent selected from an alkyl group, an aryl group, a substituted or unsubstituted amino group, or a halogen atom. Ph denotes a phenyl group.

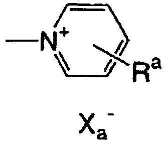

R¹ and R² independently denote a hydrocarbon group having 1 to 12 carbon atoms. From the viewpoint of storage stability of a photosensitive layer coating liquid, R¹ and R² are preferably hydrocarbon groups having two or more carbon atoms, and it is also preferable for R¹ and R² to be bonded to each other to form a 5-membered ring or a 6-membered ring.

Ar¹ and Ar² may be identical to or different from each other, and denote an optionally substituted aromatic hydrocarbon group. Preferred examples of the aromatic hydrocarbon group include a benzene ring and a naphthalene ring. Preferred examples of the substituent include a hydrocarbon group having no greater than 12 carbon atoms, a halogen atom, and an alkoxy group having no greater than 12 carbon atoms. Y¹ and Y² may be identical to or different from each other, and denote a sulfur atom or a dialkylmethylene group having no greater than 12 carbon atoms. R³ and R⁴ may be identical to or different from each other, and denote an optionally substituted hydrocarbon group having no greater than 20 carbon atoms. Preferred examples of the substituent include an alkoxy group having no greater than 12 carbon atoms, a carboxy group, and a sulfo group. R⁵, R⁶, R⁷, and R⁸ may be identical to or different from each other, and denote a hydrogen atom or a hydrocarbon group having no greater than 12 carbon atoms. From the availability of starting materials, a hydrogen atom is preferable. Furthermore, Za⁻ denotes a counteranion. When a cyanine dye represented by Formula (a) has an anionic substituent in its structure and neutralization of charge is unnecessary, Za⁻ is not required. From the viewpoint of storage stability of the photosensitive layer coating liquid, Za⁻ is preferably a halide ion, a perchlorate ion, a tetrafluoroborate ion, a hexafluorophosphate ion, or a sulfonate ion, and particularly preferably a perchlorate ion, a hexafluorophosphate ion, or an arylsulfonate ion. As a counterion, one not containing a halide ion is particularly preferable.

These IR absorbers may be added to the same layer as other components or may be added to another layer provided separately.

From the viewpoint of uniformity in the photosensitive layer and durability of the photosensitive layer, the content of these IR absorbers in the photosensitive layer is preferably 0.01 to 50 wt % relative to the total content of solids forming the photosensitive layer, more preferably 0.1 to 10 wt %, and yet more preferably 0.5 to 10 wt %.

Other preferred examples of IR absorbers include compounds described in paragraphs 0012 to 0038 of JP-A-2002-40638, paragraphs 0144 to 0174 of JP-A-2004-250158, paragraphs 0219 to 0249 of JP-A-2005-47947, paragraphs 0231 to 0260 of JP-A-2005-91617, paragraphs 0219 to 0249 of JP-A-2005-91618, paragraphs 0195 to 0224 of JP-A-2005-134893, paragraphs 0144 to 0173 of JP-A-2005-250158, paragraphs 0192 to 0201 of JP-A-2005-250438, paragraphs 0241 to 0273 of JP-A-2005-257949, paragraphs 0235 to 0268 of JP-A-2005-298567, paragraphs 0243 to 0276 of JP-A-2005-300650, paragraphs 0177 to 0186 of JP-A-2005-300817, paragraphs 0215 to 0224 of JP-A-2006-267289, paragraphs 0107 to 0124 of JP-A-2007-17948, paragraphs 0275 to 0304 of JP-A-2007-47742, paragraphs 0188 to 0206 of JP-A-2007-248863, paragraphs 0114 to 0125 of JP-A-2007-249036, paragraphs 0115 to 0123 of JP-A-2007-249037, paragraphs 0115 to 0145 of JP-A-2008-242093 and paragraphs 0040 to 0061 of JP-A-2008-249851.

Next, the sensitizing dye having a maximum absorption in the wavelength region of 350 to 450 nm is explained.

Examples of such a sensitizing dye include a merocyanine dye, a benzopyran, a coumarin, an aromatic ketone, and an anthracene.

Among sensitizing dyes having an absorption maximum in the wavelength region of 350 to 450 nm, from the viewpoint of high sensitivity a dye represented by Formula (IX) below is preferable. 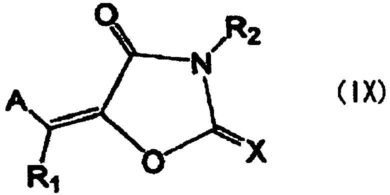 (In Formula (IX), A denotes an optionally substituted aromatic ring group or heterocyclic group, X denotes an oxygen atom, a sulfur atom, or NR₃, R₁, R₂, and R₃ independently denote a monovalent non-metallic atomic group, and A and R₁, and R₂ and R₃ may be bonded to each other to form an aliphatic or aromatic ring.)

R₁, R₂, and R₃ denote independently a monovalent non-metallic atomic group, and preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group, or a halogen atom.

Next, A in Formula (IX) denotes an optionally substituted aromatic ring group or heterocyclic group, and specific examples of the optionally substituted aromatic ring or heterocycle include the same as those described for R₁, R₂, and R₃ in Formula (IX).

Preferred specific examples of such a sensitizing dye include compounds described in paragraphs 0047 to 0053 of JP-A-2007-58170.

Furthermore, other sensitizing dyes described in paragraphs 0168 to 0218 of JP-A-2005-47947, paragraphs 0180 to 0230 of JP-A-2005-91617, paragraphs 0168 to 0218 of JP-A-2005-91618, paragraphs 0144 to 0194 of JP-A-2005-134893, paragraphs 0192 to 0242 of JP-A-2005-250158, paragraphs 0202 to 0250 of JP-A-2005-250438, paragraphs 0190 to 0240 of JP-A-2005-257949, paragraphs 0184 to 0234 of JP-A-2005-298567, paragraphs 0192 to 0242 of JP-A-2005-300650, paragraphs 0170 to 0176 of JP-A-2005-300817, paragraphs 0225 to 0273 of JP-A-2006-267289, paragraphs 0058 to 0084 of JP-A-2007-17948, paragraphs 0230 to 0274 of JP-A-2007-47742, paragraphs 0207 to 0246 of JP-A-2007-248863, paragraphs 0076 to 0113 of JP-A-2007-249036, paragraphs 0078 to 0114 of JP-A-2007-249037, paragraphs 0033 to 0038 of JP-A-2007-171406, paragraphs 0023 to 0059 of JP-A-2007-206216, paragraphs 0016 to 0043 of JP-A-2007-225701, paragraphs 0037 to 0049 of JP-A-2007-316582, paragraphs 0026 to 0115 of JP-A-2007-328243, paragraphs 0067 to 0114 of JP-A-2008-242093 are preferably used. (B) Polymerization initiator

The photosensitive layer of the lithographic printing plate precursor used in the present invention preferably contains a polymerization initiator (hereinafter, also called an 'intiator compound').

As the initiator compound in the present invention, a compound known to a person skilled in the art may be used without any restrictions. Specific examples thereof include a trihalomethyl compound, a carbonyl compound, an organic peroxide, an azo type compound, an azide compound, a metallocene compound, a hexaarylbiimidazole compound, an organic boron compound, a disulfone compound, an oxime ester compound, an onium salt compound, and an iron arene complex.

Among them, it is preferably at least one type selected from the group consisting of a hexaarylbiimidazole compound, an onium salt, a trihalomethyl compound, and a metallocene compound, and it is particularly preferably at least one type selected from the group consisting of a hexaarylbiimidazole compound and an onium salt compound.

The polymerization initiator may be used as appropriate in a combination of two or more types thereof.

As the hexaarylbiimidazole compound, there can be cited lophine dimers described in JP-B-45-37377 and JP-B-44-86516 (JP-B denotes a Japanese examined patent application publication), and examples thereof include 2,2'-bis(*o*-chlorophenyl)-4,4',5,5'-tetraphenylbiimidazole, 2,2'-bis(*o-*bromophenyl)-4,4',5,5'-tetraphenylbiimidazole, 2,2'-bis(o,*p*-dichlorophenyl)-4,4',5,5'-tetraphenylbiimidazole, 2,2'-bis(*o*-chlorophenyl)-4,4',5,5'-tetra(*m-*methoxyphenyl)biimidazole, 2,2'-bis(*o*,*o*'-dichiorophenyt)-4,4',5,5'-tetraphenylbiimidazole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o-*trifluorophenyl)-4,4',5,5'-tetraphenylbiimidazole

The hexaarylbiimidazole compound is particularly preferably used in a combination with a sensitizing dye having a maximum absorption at 300 to 450 nm.

The onium salt suitably used in the present invention is an onium salt represented by Formulae (RI-I) to (RI-III) below.

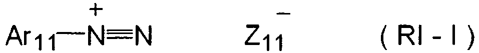

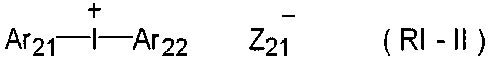

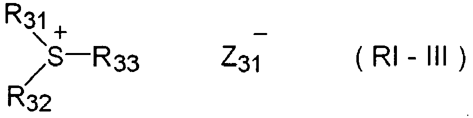

In Formula (RI-I), Ar₁₁ denotes an aryl group that has no greater than 20 carbon atoms and that may have 1 to 6 substituents. Preferable examples of the substituent include an alkyl group having 1 to 12 carbon atoms, an alkenyl group having 2 to 12 carbon atoms, an alkynyl group having 2 to 12 carbon atoms, an aryl group having 6 to 12 carbon atoms, an alkoxy group having 1 to 12 carbon atoms, an aryloxy group having 6 to 12 carbon atoms, a halogen atom, an alkylamino group having 1 to 12 carbon atoms, a dialkylamino group having 2 to 12 carbon atoms, an alkylamide group having 1 to 12 carbon atoms, an arylamide group having 6 to 12 carbon atoms, a carbonyl group, a carboxy group, a cyano group, a sulfonyl group, a thioalkyl group having 1 to 12 carbon atoms, and a thioaryl group having 6 to 12 carbon atoms. Z₁₁⁻ denotes a monovalent anion, and specific examples thereof include a halide ion, a perchlorate ion, a hexafluorophosphate ion, a tetrafluoroborate ion, a sulfonate ion, a sulfinate ion, a thiosulfonate ion, or a sulfate ion. Among them, a perchlorate ion, a hexafluorophosphate ion, a tetrafluoroborate ion, a sulfonate ion, and a sulfinate ion are preferable from the viewpoint of stability.

In Formula (RI-II), Ar₂₁ and Ar₂₂ independently denote an aryl group that has no greater than 20 carbon atoms and that may have 1 to 6 substituents. Preferable examples of the substituent include an alkyl group having 1 to 12 carbon atoms, an alkenyl group having 2 to 12 carbon atoms, an alkynyl group having 2 to 12 carbon atoms, an aryl group having 6 to 12 carbon atoms, an alkoxy group having 1 to 12 carbon atoms, an aryloxy group having 6 to 12 carbon atoms, a halogen atom, an alkylamino group having 1 to 12 carbon atoms, a dialkylamino group having 2 to 12 carbon atoms, an alkylamide group having 1 to 12 carbon atoms, an arylamide group having 6 to 12 carbon atoms, a carbonyl group, a carboxy group, a cyano group, a sulfonyl group, a thioalkyl group having 1 to 12 carbon atoms, or a thioaryl group having 6 to 12 carbon atoms.

Z₂₁⁻ denotes a monovalent anion. Specific examples thereof include a halide ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity.

In Formula (RI-III), R₃₁, R₃₂, and R₃₃ independently denote an aryl group that has no greater than 20 carbon atoms and that may have 1 to 6 substituents, an alkyl group, an alkenyl group, or an alkynyl group. Among them, the aryl group is preferable from the viewpoint of reactivity and stability. Examples of the substituent include an alkyl group having 1 to 12 carbon atoms, an alkenyl group having 2 to 12 carbon atoms, an alkynyl group having 2 to 12 carbon atoms, an aryl group having 6 to 12 carbon atoms, an alkoxy group having 1 to 12 carbon atoms, an aryloxy group having 6 to 12 carbon atoms, a halogen atom, an alkylamino group having 1 to 12 carbon atoms, a dialkylamino group having 2 to 12 carbon atoms, an alkylamide group having 1 to 12 carbon atoms, an arylamide group having 6 to 12 carbon atoms, a carbonyl group, a carboxy group, a cyano group, a sulfonyl group, a thioalkyl group having 1 to 12 carbon atoms, and a thioaryl group having 6 to 12 carbon atoms.

Z₃₁⁻ denotes a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity. Carboxylate ions described in JP-A-2001-343742 are more preferable, and carboxylate ions described in JP-A-2002-148790 are particularly preferable.

Other preferred examples of polymerization initiators include compounds described in paragraphs 0065 to 0124 of JP-A-2004-317652, paragraphs 0202 to 0264 of JP-A-2005-47947, paragraphs 0091 to 0164 of JP-A-2005-91618, paragraphs 0031 to 0104 of JP-A-2005-134893, paragraphs 0103 to 0140 of JP-A-2005-250158, paragraphs 0115 to 0189 of JP-A-2005-300650, paragraphs 0120 to 0209 of JP-A-2006-267289, paragraphs 0051 to 0054 of JP-A-2007-17948, paragraphs 0190 to 0227 of JP-A-2007-47742, paragraphs 0111 to 0185 of JP-A-2007-248863, paragraphs 0037 to 0062 of JP-A-2007-249036, paragraphs 0038 to 0063 of JP-A-2007-249037, paragraphs 0039 to 0047 of JP-A-2007-171406, paragraphs 0060 to 0115 of JP-A-2007-206216, paragraphs 0071 to 0126 of JP-A-2007-206217, paragraphs 0050 to 0059 of JP-A-2007-316582, paragraphs 0042 to 0066 of JP-A-2008-242093, paragraphs 0016 to 0054 of JP-A-2008-276167.

The polymerization initiator in the present invention may be suitably used singly or in a combination of two or more types thereof. The amount of polymerization initiator used in the photosensitive layer in the present invention is preferably 0.01 to 20 wt % relative to the weight of the total solids content of the photosensitive layer, more preferably 0.1 to 15 wt %, and yet more preferably 1.0 to 10 wt %. (C) Polymerizable compound

The photosensitive layer of the lithographic printing plate precursor used in the present invention preferably contains a polymerizable compound.

The polymerizable compound for use in the photosensitive layer in the present invention is a compound having at least one ethylenically unsaturated bond, and is selected from compounds having at least one, and preferably two or more, terminal ethylenically unsaturated bonds. Such compounds are widely known in the art and they can be used in the present invention without any particular limitation.

Examples of the monomer include an unsaturated carboxylic acid (for example, acrylic acid, methacrylic acid, itaconic acid, crotonic acid, isocrotonic acid, or maleic acid) and an ester or amide thereof, and an ester of an unsaturated carboxylic acid with an alcohol compound or an amide of an unsaturated carboxylic acid with an amine compound is preferably used.

An addition reaction product of an unsaturated carboxylic acid ester or amide having a nucleophilic substituent such as a hydroxy group, an amino group, or a mercapto group with a monofunctional or polyfunctional isocyanate or epoxy compound, or a dehydration condensation reaction product thereof with a monofunctional or polyfunctional carboxylic acid is also suitably used. Moreover, an addition reaction product of an unsaturated carboxylic acid ester or amide having an electrophilic substituent such as an isocyanate group or an epoxy group with a monofunctional or polyfunctional alcohol, amine, or thiol, or a substitution reaction product of an unsaturated carboxylic acid ester or amide having a leaving group such as a halogen group or a tosyloxy group with a monofunctional or polyfunctional alcohol, amine, or thiol is also suitably used. In addition, compounds in which the unsaturated carboxylic acid described above is replaced by an unsaturated phosphonic acid, styrene, vinyl ether, etc. can also be used.

Examples of esters that can be suitably used include aliphatic alcohol esters described in JP-B-51-47334 and JP-A-57-196231, esters having an aromatic skeleton described in JP-A-59-5240, JP-A-59-5241, and JP-A-2-226149, and esters containing an amino group described in JP-A-1-165613. The above-mentioned ester monomers can also be used as a mixture.

Examples of the amide monomer include amides having a cyclohexylene structure described in JP-B-54-21726.

Urethane-based addition polymerizable compounds produced using an addition reaction between an isocyanate and a hydroxy group are also preferably used, and specific examples thereof include vinylurethane compounds described in JP-B-48-41708.

Moreover, urethane acrylates described in JP-A-51-37193, JP-B-2-32293, and JP-B-2-16765, and urethane compounds having an ethylene oxide-based skeleton described in JP-B-58-49860, JP-B-56-17654, JP-B-62-39417 and JP-B-62-39418 are suitably used. Furthermore, a photopolymerizable composition having remarkably high photosensitive speed can be obtained by using an addition polymerizable compound having an amino structure or a sulfide structure in its molecule, described in JP-A-63-277653, JP-A-63-260909, and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191, and JP-B-52-30490. Specific unsaturated compounds described in JP-B-46-43946, JP-B-1-40337, and JP-B-1-40336, and vinylphosphonic acid-based compounds described in JP-A-2-25493 can also be cited. In some cases, a structure containing a perfluoroalkyl group described in JP-A-61-22048 can be suitably used. Moreover, photocurable monomers or oligomers described in Nippon Secchaku Kyokaishi (Journal of Japan Adhesion Society), Vol. 20, No. 7, pp. 300-308 (1984) can also be used.

The polymerizable compound used in the photosensitive layer may be used singly or in a combination of two or more types thereof.

The content of polymerizable compound in the photosensitive layer is preferably 5 to 75 wt % relative to the total solids content of the photosensitive layer, more preferably 25 to 70 wt %, and yet more preferably 30 to 60 wt %.

### (D) Binder polymer

The photosensitive layer in the lithographic printing plate precursor that can be used in the present invention preferably comprises a binder polymer.

The chemical structure of the binder polymer that can be used in the present invention is not particularly limited, but from the viewpoint of solubility in an alkaline processing solution, that is, developability, an acid group-containing organic polymer is preferable, and in particular an organic polymer containing a carboxylic acid or a salt thereof is more preferable.

Examples of the binder polymer that can be used in the present invention include a carboxylic acid-containing aqueous alkali-soluble or swelling organic polymer. Examples of such an organic polymer include addition polymers having a carboxylic acid group in a side chain such as those described in JP-A-59-44615, JP-B-54-34327, JP-B-58-12577, JP-B-54-25957, JP-A-54-92723, JP-A-59-53836, and JP-A-59-71048; that is, a methacrylic acid copolymer, an acrylic acid copolymer, an itaconic acid copolymer, a crotonic acid copolymer, a maleic acid copolymer, a partially esterified maleic acid copolymer, etc. are useful. As a binder polymer, a copolymer containing a monomer unit derived from a carboxylic acid (salt) group-containing (meth)acrylic acid ester is preferable.

Furthermore, an acidic cellulose derivative having a carboxylic acid group in a side chain, an addition product of a hydroxy group-containing addition polymer with a cyclic acid anhydride, etc. are also useful. Moreover, polyurethane resins described in JP-B-7-120040, JP-B-7-120041, JP-B-7-120042, JP-B-8-12424, JP-A-63-287944, JP-A-63-287947, JP-A-1-271741, and JP-A-11-352691 are also useful as aqueous alkali-soluble or swelling binders. As the binder polymer that can be used in the present invention, an acrylic resin, a methacrylic resin, or a urethane resin is preferably used.

Examples of materials suitable as the binder polymer that can be used in the present invention include a copolymer having (a) a carboxylic acid (including a salt thereof) group-containing monomer unit and (b) a monomer unit that imparts radical crosslinkablility.

The carboxylic acid group-containing monomer unit (a) is not particularly limited, but structures described in JP-A-2002-40652 and paragraphs 0059 to 0075 of JP-A-2005-300650 are preferably used.

The monomer unit (b) that imparts radical crosslinkablility is not particularly limited, but structures described in paragraphs 0041 to 0053 of JP-A-2007-248863 are preferably used.

The binder polymer that can be used in the present invention may have as a copolymer component a monomer unit derived from an ethylenically unsaturated compound that does not contain either the carboxylic acid group-containing monomer unit (a) or the monomer unit (b) that imparts radical crosslinkablility.

As such a monomer unit, a monomer unit derived from a (meth)acrylic acid ester or a (meth)acrylamide is preferable. In particular, a monomer unit derived from a (meth)acrylamide described in paragraphs 0061 to 0084 of JP-A-2007-272134 is preferably used. The content of the monomer, when the total number of monomer units is 100, is preferably 5 to 50 units, more preferably 5 to 35 units, and yet more preferably 5 to 25 units.

The photosensitive layer in the present invention may also employ as a binder polymer, other than an addition polymer having a combination of the above-mentioned monomer units, a urethane resin having a crosslinkable group in a side chain. The crosslinkable group referred to here is a group that can crosslink a binder polymer by a chemical reaction occurring in an image formation layer when a lithographic printing plate precursor is exposed. As long as it is a group having such a function, its chemical structure is not particularly limited and, for example, an ethylenically unsaturated group is preferable as a functional group that can undergo addition polymerization. Furthermore, examples thereof include functional groups described in paragraphs 0130 to 0139 of JP-A-2007-17948.

A polyurethane resin having a crosslinkable group in a side chain that is particularly preferably used in the present invention may be obtained by a polyaddition reaction of (i) a diisocyanate compound, (ii) a carboxyl group-containing diol compound, (iii) a crosslinkable group-containing diisocyanate compound and, as necessary, (iv) a diol compound that does not have a carboxyl group and (v) an amino group-containing compound.

Examples of compounds (i), (ii), and (iii) above include Formulae (4) to (10) and specific examples described in paragraphs 0142 to 0167 of JP-A-2007-17948. Examples of compound (iv) include Formula (A'), Formulae (a) to (e), Formulae (11) to (22), and specific compounds described in paragraphs 0180 to 0225 of JP-A-2007-17948. Examples of compound (v) include Formula (31), Formula (32) and specific compounds described in paragraphs 0227 to 0230 of JP-A-2007-17948. Other than the above-mentioned polyurethane resins, a polyurethane resin obtained by introducing a crosslinkable group into a carboxyl group-containing polyurethane by a polymer reaction as described in JP-A-2003-270775 can also be cited as an example.

In order to maintain the developability of a photosensitive layer, it is preferable for the binder polymer used to have an appropriate molecular weight, and the weight-average molecular weight is more preferably 5,000 to 300,000, and yet more preferably 20,000 to 150,000.

These binder polymers may be contained in the photosensitive layer in any amount, but the content of the binder polymer in the photosensitive layer is preferably 10 to 90 wt %, and more preferably 30 to 80 wt %.

### (E) Other photosensitive layer components

The photosensitive layer in the lithographic printing plate precursor that can be used in the present invention may further contain various additives as necessary.

As the additives, a surfactant for promoting developability and improving coated surface condition, a hydrophilic polymer for improving developability and improving the dispersion stability of microcapsules, a colorant or a printing-out agent for making visible an image area and a non-image area, a polymerization inhibitor for inhibiting unwanted thermal polymerization of a radically polymerizable compound during production or storage of a photosensitive layer, a higher fatty derivative for preventing polymerization inhibition by oxygen, inorganic particles for improving cured film strength of an image area, a hydrophilic low molecular weight compound for improving developability, a co-sensitizer or a chain transfer agent for improving sensitivity, a plasticizer for improving plasticity, etc. may be added. These compounds may employ known substances such as compounds described in, for example, JP-A-2007-171406, JP-A-2007-206216, JP-A-2007-206217, JP-A-2007-225701, JP-A-2007-225702, JP-A-2007-316582, and JP-A-2007-328243.

### Acid-crosslinking layer

As one thermal negative type image recording layer, an acid-crosslinking type image recording layer (acid-crosslinking layer) can also be cited suitably. The acid-crosslinking layer comprises a photothermal conversion substance, a thermo-acid generator, a compound that is crosslinked by an acid (crosslinking agent) as a curable compound, and an alkali-soluble polymer compound that can react with a crosslinking agent in the presence of an acid. In the acid-crosslinking layer, infrared rays that have been absorbed by the photothermal conversion substance are converted into heat, this heat decomposes the thermoacid generator to thus generate an acid, and the crosslinking agent and the alkali-soluble polymer compound are reacted and cured by the acid thus generated. Specifically, photosensitive layers described in for example JP-A-7-306528, JP-A-8-276558, JP-A-10-123701, and JP-A-10-203037 are preferably used.

### Positive-working photosensitive layer

A positive-working photosensitive composition comprises an alkali-soluble polymer compound and a photothermal conversion substance. In a positive image recording layer, the photothermal conversion substance converts light energy such as that from an infrared laser into heat, and the heat efficiently releases an interaction that lowers the alkali solubility of the alkali-soluble polymer compound. Specifically, photosensitive layers described in JP-A-11-218914, JP-A-2001-215693, JP-A-2001-305722, JP-A-2002-311570, JP-A-2002-323769, JP-A-2007-122003, JP-A-2008-64778, JP-A-2008-64959, JP-A-2008-76516, JP-A-2008-76996, JP-A-2008-197566, JP-A-2008-209774, JP-A-2008-224991, and JP-A-2008-233496 are preferably used.

### Formation of photosensitive layer

The photosensitive layer in a lithographic printing plate precursor that can be used in the present invention may be formed by dispersing or dissolving the above-mentioned necessary components in a solvent to thus prepare a coating liquid, and applying it. As a solvent used here, compounds described in paragraph 0159 of JP-A-2007-249037 are preferably used, and these solvents may be used singly or as a mixture.

The solids content concentration of the coating liquid is preferably 1 to 50 wt %.

The amount (solids content) of the photosensitive layer that the support is coated with after coating and drying may be varied depending on the use, but is preferably 0.3 to 3.0 g/m². In the above-mentioned range good sensitivity and good film properties for the photosensitive layer can be obtained.

### Protective layer

The lithographic printing plate precursor that can be used in the present invention may be provided as necessary with a protective layer on an image recording layer in order to prevent the occurrence of scratches, etc. on the image recording layer, shield it from oxygen, and prevent ablation when exposed to a high illumination intensity laser.

In the present invention, exposure is usually carried out in the atmosphere, and the protective layer prevents a low-molecular-weight compound such as oxygen or a basic substance present in the atmosphere that inhibits an image formation reaction caused in the image recording layer by exposure from contaminating the image recording layer, thus preventing inhibition of the image formation reaction by exposure in the atmosphere. Properties desired for the protective layer are therefore preferably low permeability for a low-molecular-weight compound such as oxygen and, furthermore, good transparency for light used for exposure, excellent adhesion to an image recording layer, and the ability to be easily removed during a machine development process after exposure. Various investigations have been carried out into protective layers having such properties, and they are described in detail in for example US Pat. No. 3,458,311 and JP-B-55-49729.

Furthermore, as the protective layer, protective layers described in JP-A-2008-15503 or paragraphs 0200 to 0261 of JP-A-2008-139813 can suitably be used.

### Support

The support that can be used in the lithographic printing plate precursor is not particularly limited, and any plate-shaped support that is dimensionally stable may be used, but it is preferably a hydrophilic support, and more preferably an aluminum plate.

Examples thereof include paper, paper laminated with a plastic (e.g. polyethylene, polypropylene, polystyrene, etc.), a metal plate (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinylacetal, etc.), and paper or plastic film laminated or vapor-deposited with the above metal. Preferred examples of the support include a polyester film and an aluminum plate. Among them, an aluminum plate, which has good dimensional stability and is relatively inexpensive, is preferable.

Preferred specific examples of an aluminum support and a treatment method include an aluminum support and a treatment method described in JP-A-2005-88300.

Moreover, in the present invention, high-strength aluminum may suitably be used, and specifically that described in JP-A-2008-291305 may suitably be used.

The support that can be used in the lithographic printing plate precursor is preferably one that has been subjected to a surface roughening treatment.

As the surface roughening treatment for the support, a method described in JP-A-2005-88300, etc. may be referred to.

Furthermore, the support that can be used in the lithographic printing plate precursor is preferably a support that has been subjected to an electrochemical surface roughening treatment using a hydrochloric acid aqueous solution, and more preferably a support that has been subjected to a mechanical surface roughening treatment, an electrochemical surface roughening treatment using a nitric acid aqueous solution, and an electrochemical surface roughening treatment using a hydrochloric acid aqueous solution. When the plate surface treatment agent of the present invention is used in the above-mentioned mode, the stain prevention properties for a non-image area are excellent.

The average aperture diameter of small pits in the support that has been subjected to an electrochemical surface roughening treatment using a hydrochloric acid aqueous solution is preferably 0.05 to 0.8 µm, and more preferably 0.1 to 0.6 µm. The average aperture diameter of small pits is calculated by a measurement method described in paragraphs 0029 to 0036 of JP-A-2006-272745.

### Undercoat layer

The lithographic printing plate precursor may be provided with an undercoat layer (also called a 'middle layer) for the purpose of improving adhesion between the photosensitive layer and the support and improving staining resistance.

Specific examples of such an undercoat layer (middle layer) include those described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JPA-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JPA-11-109641, JP-A-10-319600, JP-A-11-327152, JP-A-2000-10292, JP-A-2000-235254, JP-A-2000-352824, and JP-A-2001-209170.

Furthermore, in the lithographic printing plate precursor, it is preferable to provide, above the support, an undercoat layer of a compound containing a polymerizable group. The undercoat layer employing a polymerizable group-containing compound has the effects of strengthening adhesion between the support and the photosensitive layer in exposed areas and facilitating separation of the photosensitive layer from the support in unexposed areas, so that the developability can be improved.

Specific preferred examples of the undercoat layer employing a polymerizable group-containing compound include a silane coupling agent, described in JP-A-10-282679, having an addition-polymerizable ethylenic double bond reactive group, and a phosphorus compound, described in JP-A-2-304441, having an ethylenic double bond reactive group. A particularly preferred compound is a compound having both a polymerizable group such as a methacrylic group or an allyl group and a support-adsorptive group such as a sulfonic acid group, a phosphoric acid group, or a phosphoric acid ester group. In addition to the polymerizable group and the support-adsorptive group a
compound having a hydrophilicity-imparting group such as an ethylene oxide group may also be cited as a preferred compound.

Furthermore, the undercoat layer preferably comprises a phosphoric acid group- and/or phosphonic acid group-containing resin. It is particularly preferable for it to comprise a phosphonic acid group-containing resin, and an undercoat layer formed by treating with a polyvinylphosphonic acid, is preferably used. Resins having the structures below are particularly preferably used. The monomer unit ratios given in the chemical structural formulae below are expressed as molar ratios.

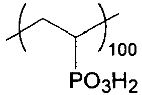

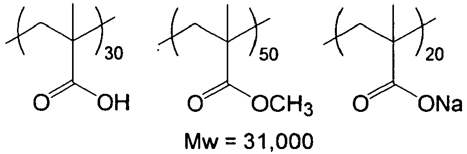

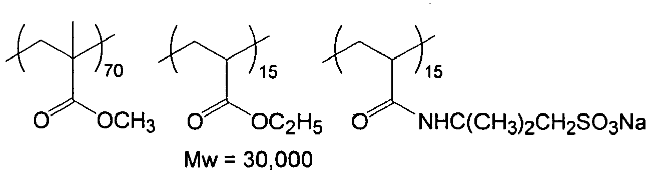

The coat weight (solids content) of the undercoat layer is preferably 0.1 to 100 mg/m², and more preferably 1 to 30 mg/m².

### Backcoat layer

After applying a surface treatment to the support or forming the undercoat layer above the support, a backcoat layer may as necessary be provided on the back surface of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as Si(OCH₃)₄, Si(OC₂H₅)₄, Si(OC₃H₇)₄, or Si(OC₄H₉)₄ is preferable since starting materials are inexpensive and readily available.

### Method for treating lithographic printing plate

The method for treating a lithographic printing plate of the present invention comprises a step of imagewise exposing a lithographic printing plate precursor (hereinafter, also called an 'exposure step'), a step of processing using a developer (hereinafter, also called a 'development step'), and a step of treating the surface of the plate using the plate surface treatment agent described above (hereinafter, also called a 'plate surface treatment step').

### Exposure step and development step

The processing referred to here means forming an image according to an exposed area by removing a non-exposed area of the photosensitive layer using a developer.

In the present invention, in a plate making process in which a lithographic printing plate is produced from a lithographic printing plate precursor, the entire surface of the lithographic printing plate precursor may be heated as necessary before exposure, during exposure, or between exposure and development. This heating promotes an image formation reaction in an image formation layer, thus giving advantages such as improvement of sensitivity, improvement of plate life, and stabilization of sensitivity. Furthermore, for the purpose of improving image strength and plate life, post-heating an image obtained by development or exposing the whole surface is
also effective. Heating prior to development is usually preferably carried out under mild conditions of no greater than 150°C. Heating after development utilizes more severe conditions. A temperature range of 200°C to 500°C is preferable.

As the lithographic printing plate precursor that can be used in the method for treating a lithographic printing plate of the present invention, those described above can suitably be used.

The lithographic printing plate precursor that can be used in the present invention is preferably a lithographic printing plate precursor that can be recorded using a laser such as a visible laser or an infrared laser. It is also possible to carry out thermal recording using a UV lamp or a thermal head.

An exposure light source that can be used in the present invention can be selected appropriately according to the mode of the photosensitive layer, and is preferably a visible laser of at least 350 nm but no greater than 450 nm, a solid laser or a semiconductor laser emitting infrared having a wavelength of at least 760 nm but no greater than 1,200 nm, and it is preferable for a lithographic printing plate precursor to be imagewise exposed thereby.

The lithographic printing plate precursor that can be used in the present invention is preferably developed using water or an alkaline aqueous solution after exposure.

As a developer and a replenisher for the lithographic printing plate precursor, a conventionally known alkali aqueous solution may be used.

Examples thereof include inorganic alkali salts such as sodium silicate, potassium silicate, trisodium phosphate, tripotassium phosphate, triammonium phosphate, disodium hydrogen phosphate, dipotassium hydrogen phosphate, diammonium hydrogen phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide, and lithium hydroxide.

Furthermore, an organic alkali agent such as monomethylamine, dimethylamine, trimethylamine, monoethylamine, diethylamine, triethylamine, monoisopropylamine, diisopropylamine, triisopropylamine, *n*-butylamine, monoethanolamine, diethanolamine, triethanolamine, monoisopropanolamine, diisopropanolamine, ethyleneimine, ethylenediamine, or pyridine may also be used.

With regard to these alkali agents, one type thereof may be used on its own or two or more types thereof may be used in combination.

The pH of the developer or the replenisher is preferably no greater than 14, more preferably 8 to 13, and yet more preferably 11 to 13.

Moreover, it is known that, when development is carried out using an automatic processor, a large quantity of lithographic printing plate precursor can be processed without replacing a developer in a development tank for a long period of time by adding to the developer the same developer or an aqueous solution (replenisher) that has a higher alkali strength than that of the developer. In the present invention, this replenishment system is preferably used.

For the purpose of enhancing promotion or suppression of developability, dispersion of development residue, and ink affinity of an image area of a printing plate, the developer and replenisher may contain as necessary various types of surfactants, organic solvents, etc.

Examples of the surfactant include anionic, cationic, nonionic, and amphoteric surfactants.

As a preferred organic solvent, benzyl alcohol, etc. can be cited. Furthermore, it is also preferable to add polyethylene glycol or a derivative thereof, polypropylene glycol or a derivative thereof, etc. It is also possible to add a non-reducing sugar such as arabitol, sorbitol, or mannitol.

Furthermore, the developer and replenisher may contain as necessary an inorganic salt-based reducing agent such as hydroquinone, resorcin, or sodium or potassium sulfite or bisulfite and, furthermore, an organic carboxylic acid, an antifoaming agent, or a water softener.

### Plate surface treatment step

The method for treating a lithographic printing plate of the present invention comprises a step of treating the surface of the plate using the plate surface treatment agent for a lithographic printing plate of the present invention.

A mode of application of the plate surface treatment agent of the present invention is not particularly limited, but it is preferable to use it with an automatic gum coater, etc. since uniform coating can be achieved.

Treatment with the plate surface treatment agent of the present invention may be carried out, without water washing, immediately after the development step, or after processing (including a water washing step, washing by circulation of running water, or washing by application of small amount of water) or after treating with a rinse liquid containing a surfactant.

Treatment of the surface of a plate with the plate surface treatment agent of the present invention is carried out using an automatic processor. This automatic processor generally includes a development section and a post-treatment section, is formed from a device for transporting a lithographic printing plate precursor, treatment solution vessels, and a spray device, and carries out development and post-treatment by spraying through a spray nozzle each of the treatment solutions that have been pumped up while transporting an exposed lithographic printing plate precursor horizontally. A method for carrying out processing by immersion-transporting through a treatment solution vessel filled with a treatment solution by means of in-liquid guide rolls, etc., or a method in which washing with water is carried out by supplying a small fixed amount of water to the surface of the plate after development and reusing the waste water as dilution water for a developer stock solution is also known.

In such automatic treatment, treatment may be carried out while supplying to each treatment solution the respective replenisher according to the amount treated, time worked, etc. It is also possible to employ a so-called disposable treatment method in which treatment is carried out using a substantially unused treatment solution. A lithographic printing plate obtained by such treatment is set in an offset printer, and used for printing a large number of sheets.

### Examples

The present invention is explained more specifically below by reference to Examples and Comparative Examples. However, the present invention should not be construed as being limited by these Examples.

'Parts' below denote 'parts by weight' unless otherwise specified.

### Examples 1 to 17 and Comparative Examples 1 to 4

### Preparation of support

As aluminum plates, those below were used.
S-1 to S-5: 0.30 mm thick aluminum plate (aluminum alloy containing Si: 0.09 wt %, Fe: 0.30 wt %, Cu: 0.013 wt %, Mn: 0.001 wt %, Mg: 0.001 wt %, Zn: 0.001 wt %, Ti: 0.027 wt %, the remainder being Al and its inevitable impurities) S-6: 0.30 mm thick aluminum plate (aluminum alloy containing Si: 0.09 wt %, Fe: 0.30 wt %, Cu: 0.013 wt %, Mn: 0.001 wt %, Mg: 0.08 wt %, Zn: 0.001 wt %, Ti: 0.027 wt %, the remainder being Al and its inevitable impurities)

### Surface treatment

With regard to the surface treatment, treatments (a) to (k) below were carried out successively. After each treatment and after washing with water liquid was removed by means of a nip roller.

### (a) Mechanical roughening treatment

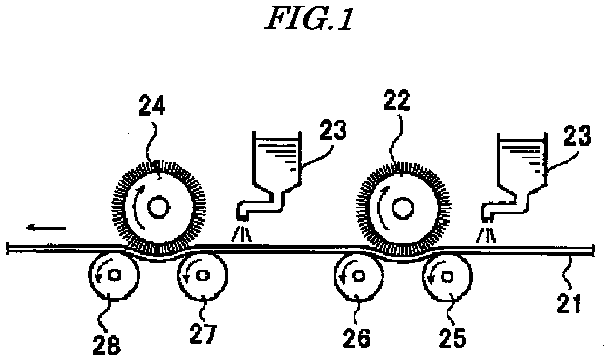

The surface of the aluminum plate was subjected to a mechanical roughening treatment by means of a rotating roller-shaped nylon brush while supplying a suspension of an abrasive (pumice) having a specific gravity of 1.12 in water as an abrasive slurry to the surface of the aluminum plate. In FIG. 1, 21 denotes an aluminum plate, 22 and 24 denote roller-shaped brushes, 23 denotes an abrasive slurry, and 25, 26, 27, and 28 denote support rollers. The abrasive had an average particle size of 30 µm and a maximum particle size of 100 µm. The material of the nylon brush was nylon 6,10, the bristle length was 45 mm, and the diameter of the bristles was 0.3 mm. The nylon brush was formed by making holes in a stainless steel tube having a diameter of 300 mm and densely implanting the bristles. Three rotating brushes were used. The distance of two support rollers (φ 200 mm) below the brush was 300 mm. The brush rollers were pressed against the aluminum plate so that the load on a drive motor for rotating the brushes increased by 7 kW from the load before pressing the brush rollers. The direction of rotation of the brushes was the same as the direction in which the aluminum plate moved. The rotational speed of the brushes was 200 rpm.

### (b) Alkali etching treatment

The aluminum plate obtained above was subjected to an etching treatment by spraying an aqueous solution (sodium hydroxide concentration 2.6 wt %, aluminum ion concentration 6.5 wt %) at 70°C so as to dissolve 10 g/m² of the aluminum plate. Subsequently, washing with water was carried out by means of a spray.

### (c) Desmutting treatment

A desmutting treatment was carried out by means of a spray using an aqueous solution having a nitric acid concentration of 1 wt % and a temperature of 30°C (containing 0.5 wt % of aluminum ion), and following this washing with water was carried out by means of a spray. The aqueous solution of nitric acid used in the desmutting treatment employed liquid waste from a step involving carrying out an electrochemical roughening treatment using alternating current in an aqueous solution of nitric acid.

### (d) Electrochemical surface roughening treatment

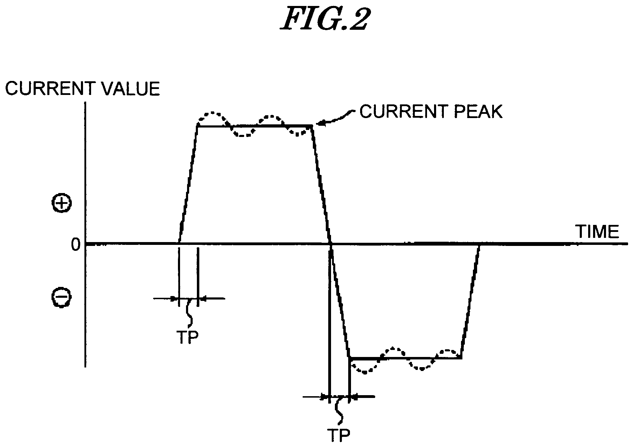

A consecutive electrochemical surface roughening treatment was carried out using a 60 Hz AC voltage. An electrolytic liquid used here was a 10.5 g/L aqueous solution of nitric acid (containing 5 g/L of aluminum ion and 0.007 wt % of ammonium ion) at a liquid temperature of 50°C. The electrochemical surface roughening treatment was carried out using a trapezoidal rectangular wave alternating current having an alternating current waveform shown in FIG. 2 and having a duty ratio of 1:1 and a time TP from zero to peak current value of 0.8 msec, with a carbon electrode as the counter electrode. Ferrite was used as an auxiliary anode.

The current density was 30 A/dm² as a peak current value, and the quantity of electricity as the total quantity of electricity when the aluminum plate was the anode was 220 C/dm². 5% of the current flowing from the power source was diverted to the auxiliary anode. Subsequently, washing with water was carried out by means of a spray.

### (e) Alkali etching treatment

The aluminum plate was subjected to an etching treatment at 32°C by means of a spray with an aqueous solution having a sodium hydroxide concentration of 26 wt % and an aluminum ion concentration of 6.5 wt % so as to dissolve 0.50 g/m² of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray.

### (f) Desmutting treatment

A desmutting treatment was carried out by means of a spray using an aqueous solution having a nitric acid concentration of 15 wt % and a temperature of 30°C (containing 4.5 wt % of aluminum ion), and following this washing with water was carried out by means of a spray. The aqueous solution of nitric acid used in the desmutting treatment employed liquid waste from the step involving carrying out the electrochemical roughening treatment using alternating current in an aqueous solution of nitric acid.

### (g) Electrochemical surface roughening treatment

A consecutive electrochemical surface roughening treatment was carried out using a 60 Hz AC voltage. An electrolytic liquid used here was a 5.0 g/L aqueous solution of hydrochloric acid (containing 5 g/L of aluminum ion) at a liquid temperature of 35°C. The electrochemical surface roughening treatment was carried out using a trapezoidal rectangular wave alternating current having an alternating current waveform with a duty ratio of 1:1 and a time TP from zero to peak current value of 0.8 msec, with a carbon electrode as the counter electrode. Ferrite was used as an auxiliary anode.

The current density was 25 A/dm² as a peak current value, and the quantity of electricity as the total quantity of electricity when the aluminum plate was the anode was 50 C/dm². Following this, washing with water was carried out by means of a spray.

### (h) Alkali etching treatment

The aluminum plate was subjected to an etching treatment at 32°C by means of a spray with an aqueous solution having a sodium hydroxide concentration of 26 wt % and an aluminum ion concentration of 6.5 wt % so as to dissolve 0.10 g/m² of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray.

### (i) Desmutting treatment

A desmutting treatment was carried out by means of a spray using an aqueous solution having a sulfuric acid concentration of 25 wt % and a temperature of 60°C (containing 0.5 wt % of aluminum ion), and following this washing with water was carried out by means of a spray.

### (j) Anodizing treatment

An anodizing treatment was carried out using an anodizing system (first and second electrolysis section lengths 6 m each, first and second power supply section lengths 3 m each, first and second power supply electrode section lengths 2.4 m each). As electrolytic liquids supplied to the first and second electrolysis sections, sulfuric acid was used. The electrolytic liquids both had a sulfuric acid concentration of 50 g/L (containing 0.5 wt % aluminum ion) and a temperature of 20°C. Subsequently, washing with water was carried out by means of a spray.

### (k) Alkali metal silicate treatment

An aluminum support obtained by the anodizing treatment was immersed in a treatment vessel with a 1 wt % aqueous solution of No. 3 sodium silicate at a temperature of 30°C for 10 sec, thus carrying out an alkali metal silicate treatment (silicate treatment). Subsequently, washing with water was carried out by means of a spray using well water, thus preparing a support that had been subjected to a surface silicate hydrophilization treatment.

An aluminum plate that had been subjected to all of steps (a) to (k) above was defined as support S-1, an aluminum plate for which the amount of aluminum plate dissolved in step (e) was 2.0 g/m², and in step (g) the electrolytic liquid was a 4.0 g/L aqueous solution of hydrochloric acid, the electric current density was 17 A/dm², and the quantity of electricity was 40 C/dm² was defined as support S-2, an aluminum plate for which the amount of aluminum plate dissolved in step (e) was 2.0 g/m², and in step (g) the electric current density was 17 A/dm² and the quantity of electricity was 40 C/dm² was defined as support S-3, an aluminum plate for which steps (a) and (e) to (g) above were omitted, the amount of aluminum plate dissolved in step (b) was 5 g/m², the nitric acid aqueous solution temperature in step (c) was 37°C, in step (d) the nitric acid aqueous solution was 10.0 g/L, the liquid temperature was 37°C, the electric current density was 35 A/dm², and the quantity of electricity was 250 C/dm², and in step (h) the sodium hydroxide concentration was 26 wt %, the aluminum ion concentration was 7.5 wt %, the temperature was 35°C, and the amount of aluminum plate dissolved was 0.2 g/m² was defined as support S-4, and an aluminum plate for which steps (a) to (d) above were omitted, in step (e) the sodium hydroxide concentration was 27 wt %, the temperature was 70°C, and the amount of aluminum plate dissolved was 1.0 g/m², in step (g) the AC voltage was a 50 Hz AC voltage, the electrolytic liquid was a 14.0 g/L aqueous solution of hydrochloric acid, the temperature was 30°C, the electric current density was 75 A/dm², and the quantity of electricity was 450 C/dm², and in step (h) the temperature was 35°C was defined as support S-5.

When the center line average roughness (expressed as Ra in accordance with JIS B0601) of each support was measured using a stylus having a diameter of 2 µm, it was 0.50 µm for supports S-1 to S-3, S-5, and S-6, and 0.30 µm for support S-4.

Subsequently, undercoat layer coating liquid (A) below was applied onto an aluminum support that had been subjected to the above-mentioned surface treatment, at a dry coat weight of 10 mg/m², and dried.

### Undercoat layer coating liquid (A)

| | |
|---|---|
| Polyvinylphosphonic acid | 0.017 parts by weight |
| Methanol | 9.00 parts by weight |
| Water | 1.00 part by weight |

### Formation of photosensitive layer

Photosensitive layer coating liquid (A) below was prepared and applied using a wire bar onto the undercoat layer formed as above, thus giving lithographic printing plate precursors used in Examples 1 to 17 and Comparative Examples 1 to 4 as described in Table 1. Drying was carried out at 125°C for 34 sec using a hot air dryer. The coat weight after drying was 1.4 g/m².

### Photosensitive layer coating liquid (A)

| | |
|---|---|
| Infrared-absorbing agent (IR-1) | 0.038 parts by weight |
| Polymerization initiator A (S-1) | 0.061 parts by weight |
| Polymerization initiator B (I-1) | 0.094 parts by weight |
| Mercapto compound (E-1) | 0.015 parts by weight |
| Ethylenically unsaturated compound (M-1) | 0.425 parts by weight |
| (product name: A-BPE-4, Shin-Nakamura Chemical Co., Ltd.) | |
| Binder polymer A (B-1) (weight-average molecular weight: 110,000) | 0.311 parts by weight |
| Binder polymer B (B-2) (weight-average molecularweight: 100,000) | 0.250 parts by weight |
| Binder polymer C (B-3) (weight-average molecular weight: 120,000) | 0.062 parts by weight |
| Additive (T-1) | 0.079 parts by weight |
| Polymerization inhibitor (Q-1) | 0.0012 parts by weight |
| Ethyl violet (EV-1) | 0.021 parts by weight |
| Fluorine-based surfactant | 0.0081 parts by weight |
| (Megafac F-780-F Dainippon Ink and Chemicals, Incorporated, methyl isobutyl ketone (MIBK) 30 wt % solution) | |
| Methyl ethyl ketone | 5.886 parts by weight |
| Methanol | 2.733 parts by weight |
| 1-Methoxy-2-propanol | 5.886 parts by weight |

The structures of infrared-absorbing agent (IR-1), polymerization initiator A (S-1), polymerization initiator B (I-1), mercapto compound (E-1), polymerizable compound (M-1), binder polymer A (B-1), binder polymer B (B-2), binder polymer C (B-3), additive (T-1), polymerization inhibitor (Q-1), and ethyl violet (EV-1) used in photosensitive layer coating liquid (A) above are shown below. In the structures below, Me denotes a methyl group, and the ratio of the monomer units in binder polymers A to C is expressed as a molar ratio.

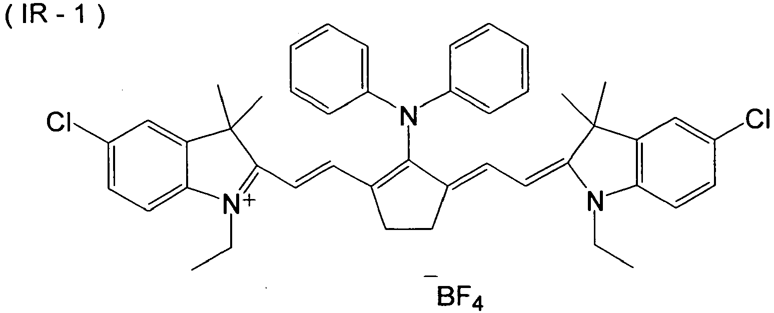

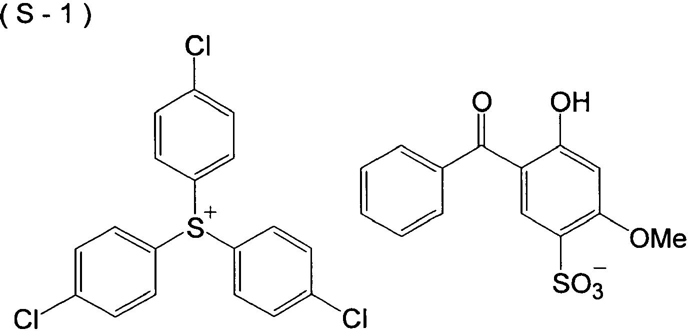

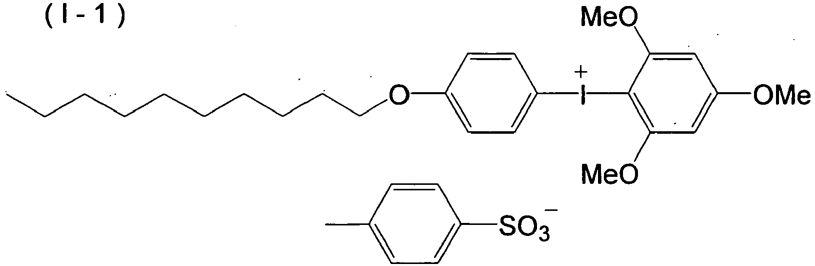

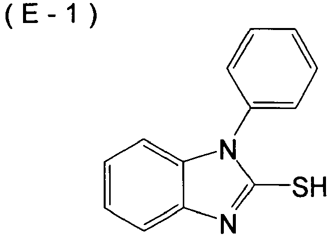

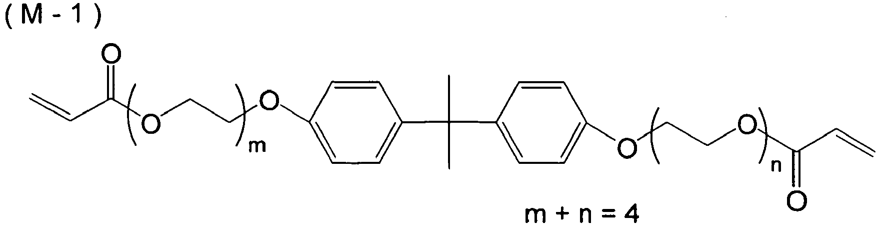

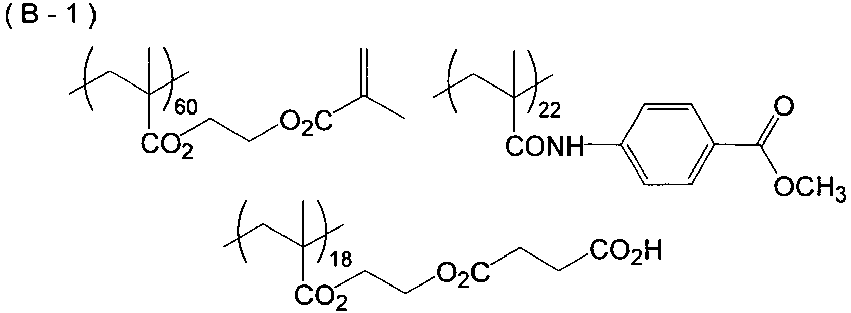

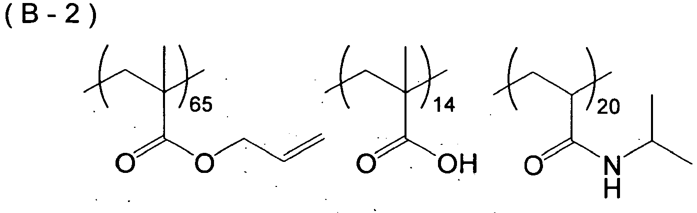

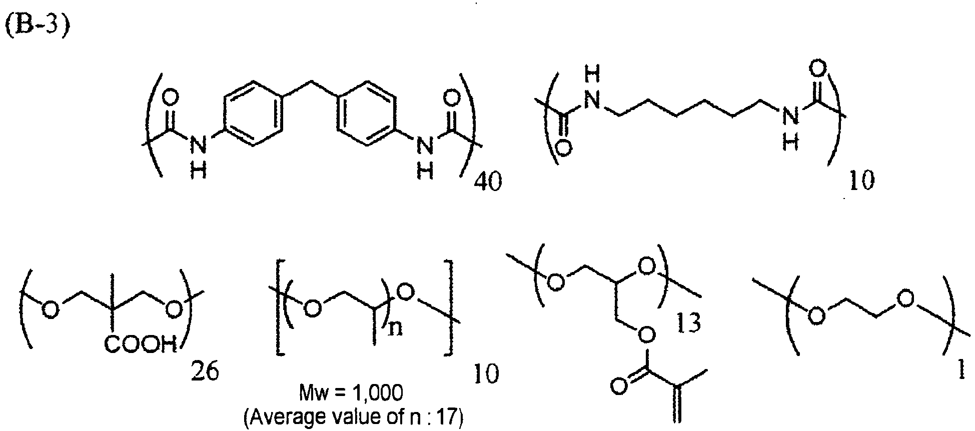

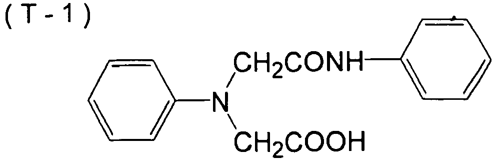

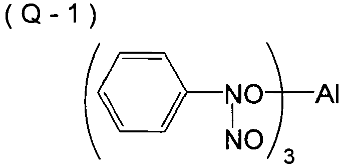

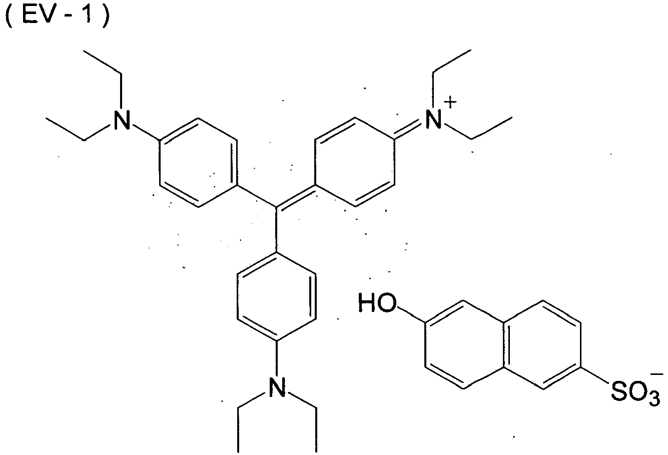

### Formation of lower protective layer

The photosensitive layer thus formed was coated with a mixed aqueous solution (lower protective layer-forming coating liquid) of synthetic mica (Somasif MEB-3L, 3.2% aqueous dispersion, Co-op Chemical Co., Ltd.), polyvinyl alcohol (Gohseran CKS-50, degree of saponification 99 mole %, degree of polymerization 300, sulfonic acid-modified polyvinyl alcohol, The Nippon Synthetic Chemical Industry Co., Ltd.), surfactant A (Emalex 710, Nihon-Emulsion Co., Ltd.), and surfactant B (Adeka Pluronic P-84: ADEKA Corp.) using a wire bar, and dried at 125°C for 30 sec using a hot air dryer.

The synthetic mica (solids content)/polyvinyl alcohol/surfactant A/surfactant B content ratio in this mixed aqueous solution (lower protective layer-forming coating liquid) was 7.5/89/2/1.5 (wt %), and the amount coated (amount of coating after drying) was 0.5 g/m².

### Formation of upper protective layer

A mixed aqueous solution (upper protective layer-forming coating liquid) of an organic filler (Art Pearl J-7P, Negami Chemical Industrial Co.), synthetic mica (Somasif MEB-3L, 3.2% aqueous dispersion, Co-op Chemical Co., Ltd.), polyvinyl alcohol (L-3266: degree of saponification 87 mole %, degree of polymerization 300, sulfonic acid-modified polyvinyl alcohol, The Nippon Synthetic Chemical Industry Co., Ltd.), a thickener (Cellogen FS-B, Dai-ichi Kogyo Seiyaku Co., Ltd.), and a surfactant (Emalex 710, Nihon-Emulsion Co., Ltd.), was applied onto the lower protective layer using a wire bar and dried at 125°C for 30 sec using a hot air dryer.

The organic filler/synthetic mica (solids content)/polyvinyl alcohol/thickener/surfactant content ratio in this mixed aqueous solution (upper protective layer-forming coating liquid) was 3.2/2.0/80.5/11.5/2.8 (wt %), and the amount coated (amount of coating after drying) was 1.76 g/m².

### Formation of backcoat layer

A backcoat layer was provided on the side of the lithographic printing plate precursor A opposite to the side provided with the photosensitive layer and protective layer in the same manner as in Example 1 of JP-A-6-35174 (US 5,464,724).

### Plate-making method

The lithographic printing plate precursor thus obtained was subjected to exposure, development processing, and drying steps in sequence.

Imagewise exposure was carried out using as an exposure light source (setter) an IR semiconductor laser (Creo Trendsetter 3244VX: equipped with a water-cooled 40 W IR semiconductor laser) under conditions of an output of 9 W, an exterior drum rotational speed of 210 rpm, and a resolution of 2,400 dpi. With regard to an exposure image, as an image for evaluation of fine non-printed lines, an image in which fine non-printed lines having a width of 5 to 100 µm (5 µm gap) were arranged was used. As an image for evaluation of plate life, an image that could be used for solid printed plate life evaluation was used.

After exposure, a heat treatment and a water washing treatment were carried out, and development processing was carried out using a 1:4 water dilution of Fujifilm developer HN-D (old product name: DH-N). The pH of the developer was 12, and the temperature of the development bath was 30°C.

The developer was supplied onto the surface of the lithographic printing plate precursor by showering from a spray pipe using a circulation pump. The tank volume for the developer was 10 liters. After development, washing with water was carried out in order to remove developer attached to the plate surface.

After the development and water washing treatments, protection of the image area was carried out using plate surface treatment agent A below in an LP1310News automatic processor (Fujifilm).

### Plate surface treatment agent A

| | |
|---|---|
| Water | 746.8 parts by weight |
| Hydroxypropylated starch (Nippon Starch Chemical Co.) | 197.6 parts by weight |
| Lithogum (IRANEX) | 33.4 parts by weight |
| Gum arabic (weight-average molecular weight: 200,000) | 61.4 parts by weight |
| Dipotassium ethylenediaminetetraacetate | 2.5 parts by weight |
| Rapisol A-80 (NOF Corporation) | 2.7 parts by weight |
| Phosphoric acid (85%) | 6.1 parts by weight |
| Monoammonium phosphate | 1.7 parts by weight |
| Sodium hydroxide | 1.7 parts by weight |
| Eleminol MON2 (Sanyo Chemical Industries, Ltd.) | 7.5 parts by weight |
| Propylene glycol | 11.1 parts by weight |
| Pionin D-1420 (Takemoto Oil & Fat Co., Ltd.) | 9.6 parts by weight |
| Benzyl alcohol | 18.4 parts by weight |
| Specific copolymer described in Table 1 | 7.0 parts by weight |

### Evaluation

### Evaluation of stain prevention properties of non-image area (evaluation of stop-staining prevention)

A lithographic printing plate precursor was subjected to forced aging at 60°C/2 days, then exposed and developed by the above-mentioned plate-making method, and treated with plate surface treatment agent A, thus giving a lithographic printing plate. This was set in a printer (Tohama Seiki 2N-600), and printing was carried out using groundwood paper, an ink (Soybi magenta, The Inctec Inc.), and dampening water (Alki, Toyo Ink Mfg. Co., Ltd.). After 50,000 sheets of printing paper used for this printing were printed, the printer was stopped and allowed to stand for 3 hours, printing was restarted, and a further 200 sheets were printed. The number of sheets until the ink completely disappeared from a non-image area was used for evaluation. The smaller the number of sheets, the smaller the amount of paper wasted after restarting printing, and the better the results.

Evaluation results for lithographic printing plates obtained in Examples 1 to 17 and Comparative Examples 1 to 4 are shown in Table 1.

**(Table 1)**

| | | Support | Photosensitive layer coating liquid | Specific copolymer | Compositional ratio of monomer units in specific copolymer (molar ratio) | Staining (sheets) |
|---|---|---|---|---|---|---|
| * | Example 1 | S-1 | A | P-1 | 20/70/10 | 30 |
| * | Example 2 | S-1 | A | P-2 | 20/80 | 30 |
| * | Example 3 | S-1 | A | P-3 | 20/80 | 30 |
| * | Example 4 | S-1 | A | P-4 | 20/80 | 30 |
| * | Example 5 | S-1 | A | P-5 | 20/80 | 30 |
| * | Example 6 | S-1 | A | P-6 | 20/80 | 35 |
| | Example 7 | S-1 | A | P-7 | 20/80 | 40 |
| | Example 8 | S-1 | A | P-8 | 20/80 | 40 |
| * | Example 9 | S-1 | A | P-9 | 20/80 | 50 |
| | Comp. Ex. 1 | S-1 | A | None | - | 100 |
| | Comp. Ex. 2 | S-1 | A | PN-1 | 100/0 | 100 |
| * | Example 10 | S-6 | A | P-1 | 20/70/10 | 30 |
| * | Example 11 | S-2 | A | P-1 | 20/70/10 | 30 |
| * | Example 12 | S-3 | A | P-1 | 20/70/10 | 30 |
| * | Example 13 | S-4 | A | P-1 | 20/70/10 | 40 |
| * | Example 14 | S-5 | A | P-1 | 20/70/10 | 30 |
| | Comp. Ex. 3 | S-4 | A | None | - | 80 |
| * | Example 15 | S-2 | A | P-3 | 20/80 | 30 |
| * | Example 16 | S-2 | A | P-3-2 | 50/50 | 40 |
| * | Example 17 | S-2 | A | P-3-3 | 70/30 | 50 |
| | Comp. Ex. 4 | S-2 | A | PN-1 | 100/0 | 100 |

| | | | | | | |
|---|---|---|---|---|---|---|
| * Reference Example | | | | | | |

The structures of P-1 to P-9, P-3-2, P-3-3, and PN-1 described in Table 1 and Table 2, which is given below, are shown below. The monomer unit ratios given in Table 1, Table 2, and the chemical structural formulae below are expressed as molar ratios.

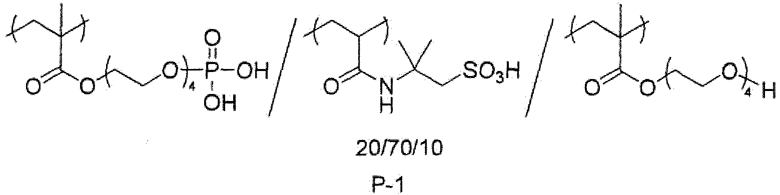

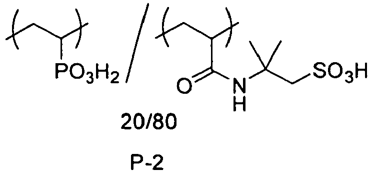

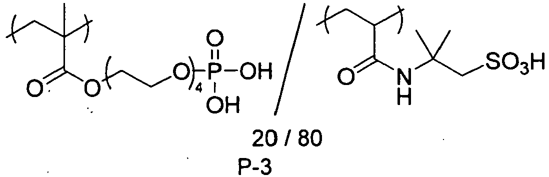

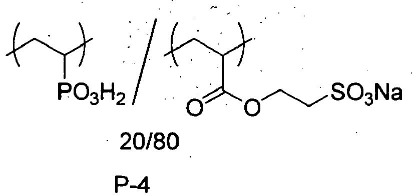

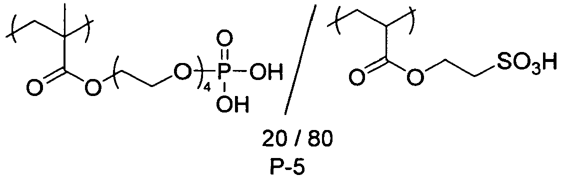

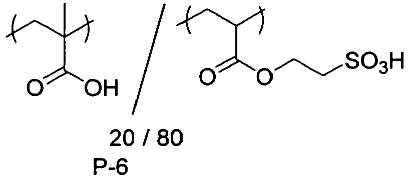

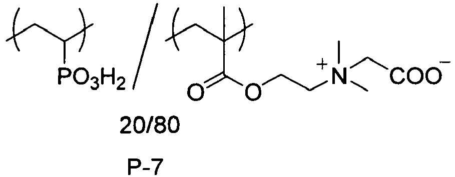

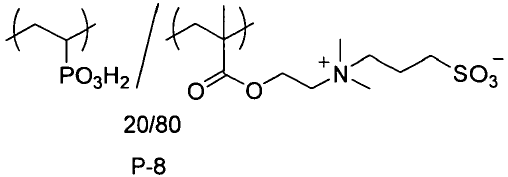

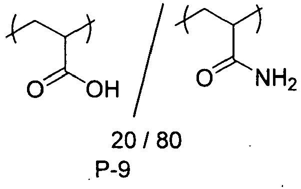

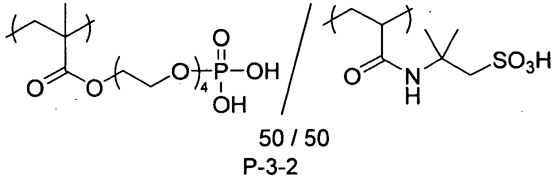

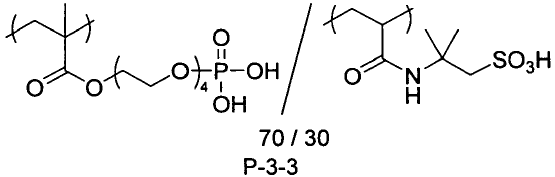

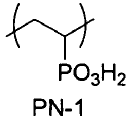

It can be seen from Table 1 that, in accordance with the plate surface treatment agent of the present invention and the method for treating a lithographic printing plate of the present invention, staining of a non-image area after printing is restarted has been improved.

### Examples 18 to 34 and Comparative Examples 5 to 8

Preparation of lithographic printing plate precursors of Examples 18 to 34 and Comparative Examples 5 to 8, making of lithographic printing plates, and evaluation of the lithographic printing plates thus made were carried out in the same manner as in the methods described in Examples 1 to 17 and Comparative Examples 1 to 4 except that, in formation of an undercoat layer, undercoat layer coating liquid (B) below was used, and undercoat layer coating liquid (B) was applied onto a support so that the dry coat weight would be 1.5 mg/m², and dried. The results are given in Table 2.

### Undercoat layer coating liquid (B)

| | |
|---|---|
| Polymer below | 0.3 parts by weight |
| Pure water | 60.0 parts by weight |
| Methanol | 939.7 parts by weight |

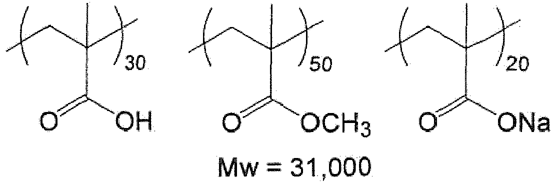

**(Table 2)**

| | | Support | Photosensitive layer coating liquid | Specific copolymer | Compositional ratio of monomer units in specific copolymer (molar ratio) | Staining (sheets) |
|---|---|---|---|---|---|---|
| * | Example 18 | S-1 | A | P-1 | 20/70/10 | 30 |
| * | Example 19 | S-1 | A | P-2 | 20/80 | 30 |
| * | Example 20 | S-1 | A | P-3 | 20/80 | 30 |
| * | Example 21 | S-1 | A | P-4 | 20/80 | 30 |
| * | Example 22 | S-1 | A | P-5 | 20/80 | 30 |
| * | Example 23 | S-1 | A | P-6 | 20/80 | 35 |
| | Example 24 | S-1 | A | P-7 | 20/80 | 40 |
| | Example 25 | S-1 | A | P-8 | 20/80 | 40 |
| * | Example 26 | S-1 | A | P-9 | 20/80 | 50 |
| | Comp. Ex. 5 | S-1 | A | None | - | 100 |
| | Comp. Ex. 6 | S-1 | A | PN-1 | 100/0 | 100 |
| * | Example 27 | S-6 | A | P-1 | 20/70/10 | 30 |
| * | Example 28 | S-2 | A | P-1 | 20/70/10 | 30 |
| * | Example 29 | S-3 | A | P-1 | 20/70/10 | 30 |
| * | Example 30 | S-4 | A | P-1 | 20/70/10 | 40 |
| * | Example 31 | S-5 | A | P-1 | 20/70/10 | 30 |
| | Comp. Ex. 7 | S-4 | A | None | - | 80 |
| * | Example 32 | S-2 | A | P-3 | 20/80 | 30 |
| * | Example 33 | S-2 | A | P-3-2 | 50/50 | 40 |
| * | Example 34 | S-2 | A | P-3-3 | 70/30 | 50 |
| * | Comp. Ex. 8 | S-2 | A | PN-1 | 100/0 | 100 |

| | | | | | | |
|---|---|---|---|---|---|---|
| * Reference Example | | | | | | |

It can be seen from Table 2 that, in accordance with the plate surface treatment agent of the present invention and the method for treating a lithographic printing plate of the present invention, staining of a non-image area after printing is restarted has been improved.

### Examples 35 to 39 and Comparative Examples 9 and 10

### Formation of photosensitive layer

Photosensitive layer coating liquid (B) having the composition below was applied onto a support using a wire bar and then dried in an oven at 90°C for 60 sec, thus giving lithographic printing plate precursor B used in Examples 35 to 39 and Comparative Examples 9 and 10. The dry coat weight was 1.3 g/m².

### Photosensitive layer coating liquid (B)

| | |
|---|---|
| Binder polymer (1) below (weight-average molecular weight: 80,000) | 0.34 parts by weight |
| Polymerizable compound (1) below | 0.68 parts by weight |
| (PLEX6661-O, Evonik Degussa Japan) | |
| Sensitizing dye (1) below | 0.06 parts by weight |
| Polymerization initiator (1) below | 0.18 parts by weight |
| Chain transfer agent (1) below | 0.02 parts by weight |
| ε-Phthalocyanine pigment dispersion | 0.40 parts by weight |
| (pigment: 15 parts by weight, dispersant (allyl methacrylate/methacrylic acid copolymer (copolymer molar ratio 83/17)): 10 parts by weight, cyclohexanone: 15 parts by weight) | |
| Thermal polymerization inhibitor | 0.01 parts by weight |
| (aluminum *N*-nitrosophenylhydroxylamine) | |
| Fluorine-based surfactant (1) below (weight-average molecular weight: 11,000) | 0.001 parts by weight |
| Polyoxyethylene-polyoxypropylene condensate | 0.02 parts by weight |
| (Pluronic L44, ADEKA Corp.) | |
| Yellow pigment dispersion | 0.04 parts by weight |
| (yellow pigment Novoperm Yellow H2G (Clariant): 15 parts by weight, dispersant (allyl methacrylate/methacrylic acid copolymer (copolymer molar ratio 83/17)): 10 parts by weight, cyclohexanone: 15 parts by weight) | |
| 1-Methoxy-2-propanol | 3.5 parts by weight |
| Methyl ethyl ketone | 8.0 parts by weight |

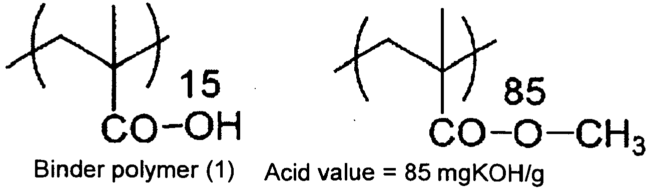

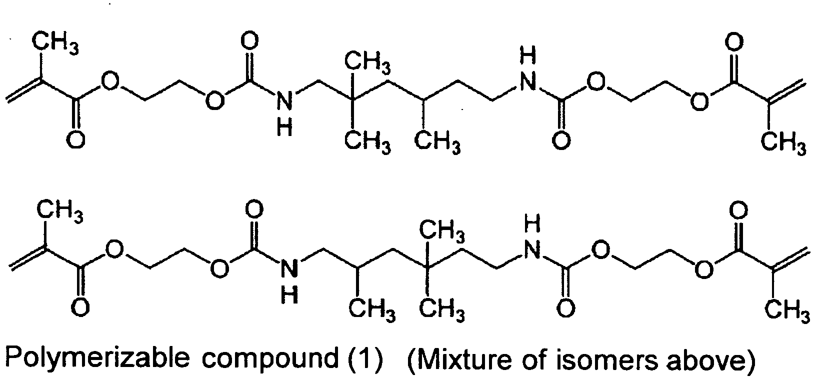

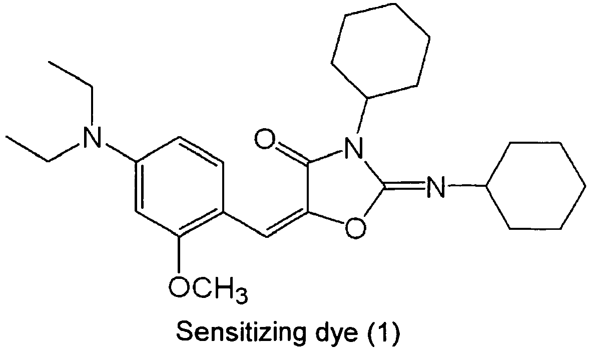

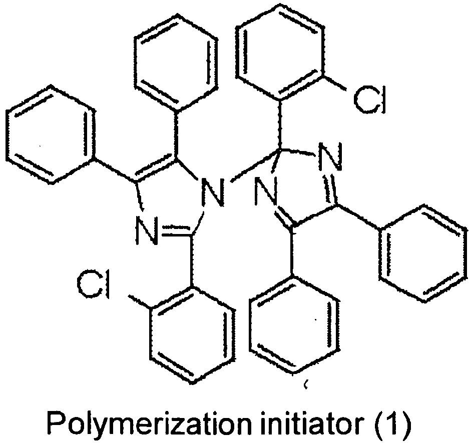

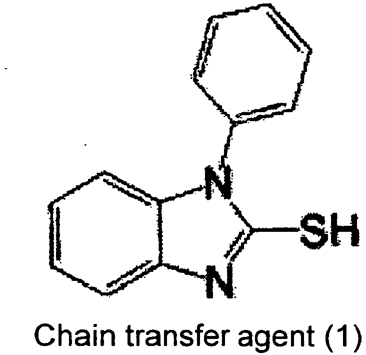

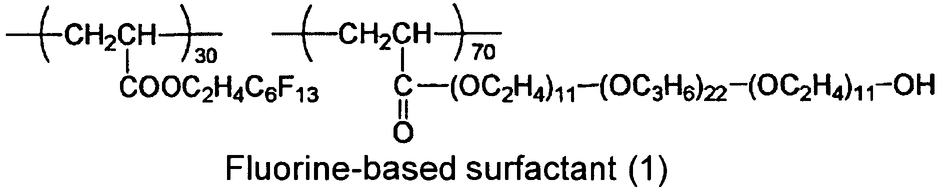

### Formation of protective laver 1

A protective layer was formed by coating the photosensitive layer with protective layer coating liquid (B) having the composition below using a wire bar at a dry coat weight of 1.0 g/m² and drying at 125°C for 70 sec, thus giving a lithographic printing plate precursor.

### Protective layer coating liquid (B)

| | |
|---|---|
| Mica dispersion (B) | 0.6 parts by weight |
| Sulfonic acid-modified polyvinyl alcohol | 0.8 parts by weight |
| (Gohseran CKS-50, The Nippon Synthetic Chemical Industry Co., Ltd., degree of saponification: 99 mole %, average degree of polymerization: 300, degree of modification: about 0.4 mole %) | |
| Poly(vinylpyrrolidone/vinyl acetate (1/1)) (molecula rweight 70,000) | 0.001 parts by weight |
| Surfactant (Emalex 710, Nihon-Emulsion Co., Ltd.) | 0.002 parts by weight |
| Water | 13 parts by weight |

### Preparation of mica dispersion (B)

32 parts by weight of synthetic mica (Somasif ME-100, Co-op Chemical Co., Ltd., aspect ratio: at least 1,000) was added to 368 parts by weight of water and dispersed using a homogenizer until the average particle size (laser scattering method) became 0.5 µm, thus giving mica dispersion (B).

### (1) Exposure, development, and printing

The lithographic printing plate precursor thus obtained was imagewise exposed using a Vx9600 violet semiconductor laser plate setter (equipped with an InGaN semiconductor laser, 405 nm ± 10 nm emission/30 mW output) (FUJIFILM Electronic Imaging Ltd.). With regard to an exposure image, as an image for evaluation of fine non-printed lines, an image in which fine non-printed lines having a width of 5 to 100 µm (5 µm gap) were arranged was used. As an image for evaluation of plate life, an image that could be used for solid printed plate life evaluation was used. Image rendering was carried out by imagewise exposure at a resolution of 2,400 dpi and a plate surface exposure of 0.05 mJ/cm².

Subsequently, preheating was carried out using an IP850HD automatic processor (G & J Corp.) at 110°C for 30 sec, development was then carried out at 25°C for a development time of 28 sec using a 1:4 dilution (pH 12) of developer DV-2 (Fujifilm), and a water washing treatment was carried out. Plate surface treatment was carried out by changing the additive of plate surface treatment agent A to an additive given in Table 3 below.

Furthermore, forced aging at 60°C/2 days was carried out in the same manner as in Example 1, the above-mentioned exposure, development, and a plate surface treatment were carried out, and stop-staining prevention was evaluated. The evaluation results are shown in Table 3.

**(Table 3)**

| | | Support | Coating liquid for photosensitive layer | Specific copolymer | Compositional ratio of monomer units in specific copolymer (molar ratio) | Staining (sheets) |
|---|---|---|---|---|---|---|
| * | Example 35 | S-4 | B | P-1 | 20/70/10 | 40 |
| * | Example 36 | S-4 | B | P-2 | 20/80 | 40 |
| * | Example 37 | S-4 | B | P-3 | 20/80 | 40 |
| | Example 38 | S-4 | B | P-7 | 20/80 | 50 |
| * | Example 39 | S-4 | B | P-9 | 20/80 | 60 |
| | Comp. Ex. 9 | S-4 | B | None | - | 100 |
| | Comp. Ex. 10 | S-4 | B | PN-1 | 100/0 | 100 |

| | | | | | | |
|---|---|---|---|---|---|---|
| * Reference Example | | | | | | |

It can be seen from Table 3 that, in accordance with the plate surface treatment agent of the present invention and the method for treating a lithographic printing plate of the present invention, staining of a non-image area after printing is restarted has been improved.

### Examples 40 to 44 and Comparative Examples 11 and 12

Preparation of lithographic printing plate precursors of Examples 40 to 44 and Comparative Examples 11 and 12, making of lithographic printing plates, and evaluation of the lithographic printing plates thus made were carried out in the same manner as in the methods described in Examples 35 to 39 and Comparative Examples 9 and 10 except that in formation of the undercoat layer the middle layer coating liquid below was used; the middle layer coating liquid was applied using a wire bar coater onto a support so that the dry coat weight would be 10 mg/m², and dried at 80°C for 20 sec. The results are given in Table 4.

### Middle layer coating liquid

| | |
|---|---|
| Sol liquid below | 100 parts by weight |
| Methanol | 900 parts by weight |

### Sol liquid

| | |
|---|---|
| Phosmer PE (Uni-Chemical Co., Ltd.) | 5 parts by weight |
| Methanol | 45 parts by weight |
| Water | 10 parts by weight |
| 85 wt % phosphoric acid | 5 parts by weight |
| Tetraethoxysilane | 20 parts by weight |
| 3-Methacryloxypropyltrimethoxysilane | 15 parts by weight |

**(Table 4)**

| | | Support | Photosensitive layer coating liquid | Specific copolymer | Compositional ratio of monomer units in specific copolymer (molar ratio) | Staining (sheets) |
|---|---|---|---|---|---|---|
| * | Example 40 | S-4 | B | P-1 | 20/70/10 | 40 |
| * | Example 41 | S-4 | B | P-2 | 20/80 | 40 |
| * | Example 42 | S-4 | B | P-3 | 20/80 | 40 |
| | Example 43 | S-4 | B | P-7 | 20/80 | 50 |
| * | Example 44 | S-4 | B | P-9 | 20/80 | 60 |
| | Comp. Ex. 11 | S-4 | B | None | - | 100 |
| | Comp. Ex. 12 | S-4 | B | PN-1 | 100/0 | 100 |

| | | | | | | |
|---|---|---|---|---|---|---|
| * Reference Example | | | | | | |

It can be seen from Table 4 that, in accordance with the plate surface treatment agent of the present invention and the method for treating a lithographic printing plate of the present invention, staining of a non-image area after printing is restarted has been improved.

## Claims

1. A method for treating a lithographic printing plate using an automatic processor comprising the steps of:
imagewise exposing a lithographic printing plate precursor;
processing using a developer; and
carrying out a plate surface treatment using a plate surface treatment agent comprising a vinyl copolymer comprising a monomer unit having at least one group selected from a phosphonic acid group, a phosphoric acid group, a carboxylic acid group, and a salt of these groups and a monomer unit having a betaine structure represented by Formulae (U-7) or (U-8): 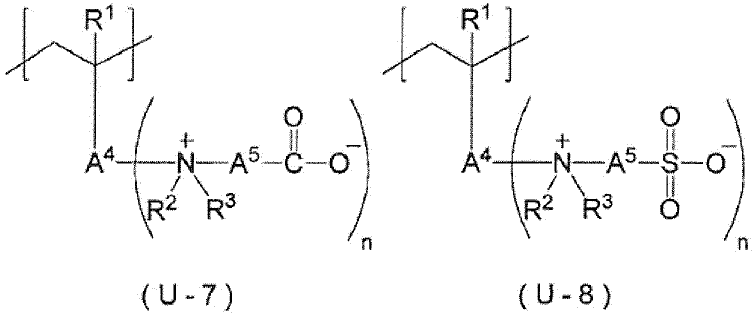
wherein R¹ denotes a hydrogen atom or an alkyl group; R² and R³ independently denote a hydrogen atom or a monovalent hydrocarbon group; A⁴ denotes an (n+1)-valent organic group; the A⁵s independently denote a divalent organic group and n denotes an integer of 1 or more.

2. A method according to Claim 1, wherein the monomer unit having at least one group selected from a phosphonic acid group, a phosphoric acid group, a carboxylic acid group, and a salt of these groups is a monomer unit having at least one group selected from a phosphonic acid group, a phosphoric acid group and a salt of these groups.

3. A method according to Claim 1 or Claim 2, wherein the copolymer comprises, relative to the total monomer units of the copolymer, 2-70 mole % of the monomer units having at least one group selected from a phosphonic acid group, a phosphoric acid group, a carboxylic acid group, and a salt of these groups.

4. A method according to any preceding Claim, wherein the copolymer comprises, relative to the total monomer units of the copolymer, 30-98 mole % of the monomer units having a betaine structure.

5. A method according to any preceding Claim, wherein the plate surface treatment agent comprises 0.005 to 10 wt.% of the vinyl copolymer.

6. A method according to any preceding Claim, wherein the plate surface treatment agent further comprises a water-soluble polymer compound other than the vinyl copolymer.

7. A method according to Claim 6, wherein the water-soluble polymer compound is gum Arabic, a cellulose derivative and a modified product thereof, polyvinyl alcohol and a derivative thereof, polyvinylpyrrolidone, a vinyl methyl ether/maleic anhydride copolymer, a vinyl acetate/maleic anhydride copolymer, a styrene/maleic anhydride copolymer, a water-soluble soybean polysaccharide, starch, a starch derivative, pullulan, a pullulan derivative, gelatine or hemicellulose extracted from soybean.

8. A method according to Claim 6 or Claim 7, wherein the water-soluble polymer compound has a content of 0.1 to 25 wt.% relative to the total weight of the plate surface treatment agent.

9. A method according to any preceding Claim, wherein the developer is an alkaline aqueous solution.

10. A method according to any preceding Claim, wherein the lithographic printing plate precursor has a support that has been subjected to an electrochemical surface roughening treatment with a hydrochloric acid aqueous solution.

11. A method according to any preceding Claim, wherein the lithographic printing plate precursor has a photosensitive layer comprising a sensitizing dye, a polymerization initiator and a binder polymer.

## Patentansprüche

1. Verfahren zur Behandlung einer Lithografiedruckplatte unter Verwendung einer automatischen Behandlungsvorrichtung, umfassend die Schritte:
bildweises Belichten eines Lithografiedruckplattenvorläufers;
Verarbeitung unter Verwendung eines Entwicklers; und
Durchführen einer Plattenoberflächenbehandlung unter Verwendung eines Plattenoberflächenbehandlungsmittels, das ein Vinyl-Copolymer, umfassend eine Monomereinheit mit zumindest einer Gruppe, ausgewählt aus einer Phosphonsäuregruppe, einer Phosphorsäuregruppe, einer Carbonsäuregruppe und einem Salz dieser Gruppen, und eine Monomereinheit mit einer Betainstruktur der Formel (U-7) oder (U-8) umfasst: 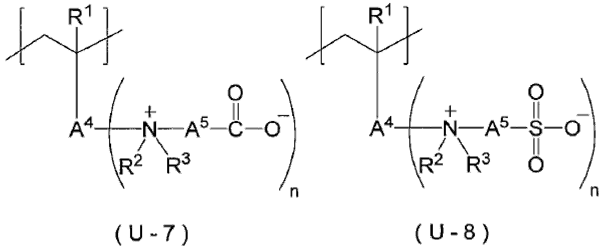
worin R¹ ein Wasserstoffatom oder eine Alkylgruppe bezeichnet; R² und R³ unabhängig ein Wasserstoffatom oder eine monovalente Kohlenwasserstoffgruppe bezeichnen; A⁴ eine (n+1)-valente organische Gruppe bezeichnet; die A⁵ unabhängig eine divalente organische Gruppe bezeichnen und n eine ganze Zahl von 1 oder mehr bezeichnet.

2. Verfahren gemäss Anspruch 1, wobei die Monomereinheit mit zumindest einer Gruppe, ausgewählt aus einer Phosphonsäuregruppe, einer Phosphorsäuregruppe, einer Carbonsäuregruppe und einem Salz dieser Gruppen, eine Monomereinheit mit zumindest einer Gruppe, ausgewählt aus einer Phosphonsäuregruppe, einer Phosphorsäuregruppe und einem Salz dieser Gruppen ist.

3. Verfahren gemäss Anspruch 1 oder Anspruch 2, wobei das Copolymer, bezogen auf die gesamten Monomereinheiten des Copolymers, 2 bis 70 mol-% der Monomereinheiten mit zumindest einer Gruppe, ausgewählt aus einer Phosphonsäuregruppe, einer Phosphorsäuregruppe, einer Carbonsäuregruppe und einem Salz dieser Gruppen, umfasst.

4. Verfahren gemäss einem der vorhergehenden Ansprüche, wobei das Copolymer, bezogen auf die gesamten Monomereinheiten des Copolymers, 30 bis 98 mol-% der Monomereinheiten mit einer Betainstruktur umfasst.

5. Verfahren gemäss einem der vorhergehenden Ansprüche, wobei das Plattenoberflächenbehandlungsmittel 0,005 bis 10 Gew.% des Vinyl-Copolymers umfasst.

6. Verfahren gemäss einem der vorhergehenden Ansprüche, wobei das Plattenoberflächenbehandlungsmittel ferner eine andere wasserlösliche Polymerverbindung als das Vinyl-Copolymer umfasst.

7. Verfahren gemäss Anspruch 6, wobei die wasserlösliche Polymerverbindung Gummi arabicum, ein Cellulosederivat und ein modifiziertes Produkt davon, Polyvinylalkohol und ein Derivat davon, Polyvinylpyrrolidon, ein Vinylmethylether/Maleinsäureanhydrid-Copolymer, ein Vinylacetat/Maleinsäureanhydrid-Copolymer, ein Styrol/Maleinsäureanhydrid-Copolymer, ein wasserlösliches Sojabohnenpolysaccharid, Stärke, ein Stärkederivat, Pullulan, ein Pullulanderivat, Gelatine oder aus Sojabohnen extrahierte Hemicellulose ist.

8. Verfahren gemäss Anspruch 6 oder Anspruch 7, wobei die wasserlösliche Polymerverbindung, bezogen auf das Gesamtgewicht des Plattenoberflächenbehandlungsmittels, einen Gehalt von 0,1 bis 25 Gew.%aufweist.

9. Verfahren gemäss einem der vorhergehenden Ansprüche, wobei der Entwickler eine wässrig alkalische Lösung ist.

10. Verfahren gemäss einem der vorhergehenden Ansprüche, wobei der Lithografiedruckplattenvorläufer einen Träger aufweist, der einer elektrochemischen Oberflächenaufrauhungsbehandlung mit einer wässrigen Salzsäurelösung unterzogen worden ist.

11. Verfahren gemäss einem der vorhergehenden Ansprüche, wobei der Lithografiedruckplattenvorläufer eine lichtempfindliche Schicht aufweist, die einen Sensibilisierungsfarbstoff, einen Polymerisationsinitiator und ein Bindemittelpolymer umfasst.

## Revendications

1. Procédé de traitement d'une plaque d'impression lithographique en utilisant un dispositif de traitement automatique comprenant les étapes consistant à :
exposer selon une image un précurseur de plaque d'impression lithographique ;
traiter en utilisant un révélateur ; et
effectuer un traitement de surface de plaque en utilisant un agent de traitement de surface de plaque comprenant un copolymère de vinyle comprenant une unité monomère ayant au moins un groupement sélectionné parmi un groupement acide phosphonique, un groupement acide phosphorique, un groupement acide carboxylique et un sel de ces groupements et une unité monomère ayant une structure de type bétaïne représentés par les formules (U-7) ou (U-8) : 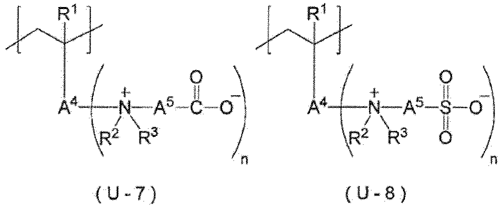
dans lesquelles R¹ désigne un atome d'hydrogène ou un groupement alkyle ; R² et R³ désignent indépendamment un atome d'hydrogène ou un groupement hydrocarboné monovalent; A⁴ désigne un groupement organique (n + 1)valent ; les A⁵ désignent indépendamment un groupement organique divalent et n désigne un entier de 1 ou plus.

2. Procédé selon la revendication 1, dans lequel l'unité monomère ayant au moins un groupement sélectionné parmi un groupement acide phosphonique, un groupement acide phosphorique, un groupement acide carboxylique et un sel de ces groupements est une unité monomère ayant au moins un groupement sélectionné parmi un groupement acide phosphonique, un groupement acide phosphorique et un sel de ces groupements.

3. Procédé selon la revendication 1 ou la revendication 2, dans lequel le copolymère comprend, par rapport à la totalité des unités monomères du copolymère, 2 à 70 % en mole des unités monomères ayant au moins un groupement sélectionné parmi un groupement acide phosphonique, un groupement acide phosphorique, un groupement acide carboxylique et un sel de ces groupements.

4. Procédé selon l'une quelconque des revendications précédentes, dans lequel le copolymère comprend, par rapport à la totalité des unités monomères du copolymère, 30 à 98 % en mole des unités monomères ayant une structure de type bétaïne.

5. Procédé selon l'une quelconque des revendications précédentes, dans lequel l'agent de traitement de surface de plaque comprend 0,005 à 10 % en poids du copolymère de vinyle.

6. Procédé selon l'une quelconque des revendications précédentes, dans lequel l'agent de traitement de surface de plaque comprend en outre un composé polymère hydrosoluble autre que le copolymère de vinyle.

7. Procédé selon la revendication 6, dans lequel le composé polymère hydrosoluble est de la gomme arabique, un dérivé de cellulose et un produit modifié de celui-ci, du poly(alcool vinylique) et un dérivé de celui-ci, de la polyvinylpyrrolidone, un copolymère d'éther vinylméthylique et d'anhydride maléique, un copolymère d'acétate de vinyle et d'anhydride maléique, un copolymère de styrène et d'anhydride maléique, un polysaccharide de haricot de soja hydrosoluble, de l'amidon, un dérivé d'amidon, du pullulane, un dérivé de pullulane, de la gélatine ou de l'hémicellulose extraite du haricot de soja.

8. Procédé selon la revendication 6 ou la revendication 7, dans lequel le composé polymère hydrosoluble a une teneur de 0,1 à 25 % en poids par rapport au poids total de l'agent de traitement de surface de plaque.

9. Procédé selon l'une quelconque des revendications précédentes, dans lequel le révélateur est une solution aqueuse alcaline.

10. Procédé selon l'une quelconque des revendications précédentes, dans lequel le précurseur de plaque d'impression lithographique a un support qui a été soumis à un traitement de rugosification de surface électrochimique avec une solution aqueuse d'acide chlorhydrique.

11. Procédé selon l'une quelconque des revendications précédentes, dans lequel le précurseur de plaque d'impression lithographique a une couche photosensible comprenant un colorant sensibilisateur, un initiateur de polymérisation et un polymère liant.
